# EUROPEAN PATENT APPLICATION

(11) **EP 4 525 033 A1**
(43) Date of publication of application: **19.03.2025**
(21) Application number: 23803476.3
(22) Date of filing: 27.04.2023
(51) Int. Cl.: H01L 23/02, H01L 27/146

(54) **SEMICONDUCTOR DEVICE, ELECTRONIC APPARATUS, AND METHOD FOR PRODUCING SEMICONDUCTOR DEVICE**

(30) Priority: 11.05.2022 JP 2022078474
(71) Applicant: Sony Semiconductor Solutions Corporation, Atsugi-shi, Kanagawa 243-0014 (JP)
(72) Inventor: HOSOKAWA, Kohyoh, Atsugi-shi, Kanagawa 243-0014 (JP)
(74) Representative: MFG Patentanwälte Meyer-Wildhagen Meggle-Freund Gerhard PartG mbB
(86) International application number: PCT/JP2023/016780
(87) International publication number: WO 2023/218997

(57) **Abstract**

Regarding a semiconductor device, it is possible to easily remove a cover member without leaving an adhesive for fixing the cover member in a state where the cover member is removed from a package main body portion, and it is possible to suppress entry of dust into a cavity without causing deformation of the package at a time of reflow.

The semiconductor device includes: a semiconductor element; a package main body portion which includes a substrate portion on which the semiconductor element is installed, and a frame portion which is provided on the substrate portion so as to surround the semiconductor element and has an opening portion formed on an upper side; a cover member which is provided on the frame portion and closes the opening portion; and a covering portion which covers the package main body portion and the cover member so as to surround the package main body portion and the cover member from a side, thereby performing at least one of fixing the cover member to the frame portion or fixing a member forming the frame portion to a member forming the substrate portion.

## Description

### TECHNICAL FIELD

The present disclosure relates to a semiconductor device, an electronic device, and a method for manufacturing the semiconductor device.

### BACKGROUND ART

Conventionally, as a semiconductor device including a semiconductor element (semiconductor chip) such as an imaging element such as a CMOS image sensor or a light emitting element such as a semiconductor laser, there is a semiconductor device having a hollow package structure in which an upper opening portion of a box-shaped package main body portion having a semiconductor chip installed therein is sealed with a cover member such as transparent glass. The cover member is, for example, a member for preventing foreign matter from being mixed into the package.

Regarding the package structure as described above, for example, when the semiconductor device is incorporated into a predetermined set structure forming an electronic device such as a camera device, the cover member is removed from the package main body portion for the reason that, for example, the cover member causes ghost, flare or an error in optical path distance, or causes loss of light received by the semiconductor chip. That is, as one mode of use of the semiconductor device, the semiconductor device is used with the cover member once attached to the package main body portion removed.

Regarding the cover member, Patent Document 1 discloses a configuration in which a transparent cover tape is attached to an upper surface of a support substrate forming a package with an adhesive so as to cover the semiconductor chip from above.

Furthermore, Patent Document 2 discloses a configuration in which a cover glass, which is the cover member, is removably fixed to a housing forming the package main body portion with an adhesive as a means for easy attachment and detachment. Patent Document 2 discloses that the adhesive has such an adhesive strength as to prevent the cover glass from separating during handling such as transportation of an imaging device or processing and to allow the cover glass to separate without breaking the housing or the cover glass.

### CITATION LIST

### PATENT DOCUMENT

Patent Document 1: Japanese Patent Application Laid-Open No. 2003-347532
Patent Document 2: Japanese Patent Application Laid-Open No. 11-355508

### SUMMARY OF THE INVENTION

### PROBLEMS TO BE SOLVED BY THE INVENTION

In the configuration disclosed in Patent Document 1, the cover tape is temporarily attached to protect an image sensor, which is a semiconductor chip, on the premise that the cover tape is finally removed. Such a cover tape has a concern in terms of heat resistance against reflow heat when the semiconductor device is installed on a set substrate and durability against long-term actual use. Furthermore, since the cover tape is merely adhered to the upper surface of the package with an adhesive, the cover tape may be peeled off. When the cover tape is peeled off, the exposed image sensor is not protected from dust or the like.

Patent Document 2 includes a description of the adhesive strength of the adhesive for fixing the cover glass, but does not specifically disclose a material of the adhesive, a bonding method, and the like. For this reason, it is difficult to obtain the adhesive strength of the adhesive as described above after reflow installation on the set substrate or the like, and the technology disclosed in Patent Document 2 has poor feasibility.

Furthermore, according to the configuration using the adhesive for fixing the cover member as in Patent Documents 1 and 2, the adhesive as a residue exists on the upper surface of the package main body portion or the like in a state where the cover member is removed. The adhesive remaining in the package main body portion may adhere to the semiconductor chip inside the package as dust, or reflect incident light on the semiconductor chip to cause flare.

Furthermore, according to the configuration using the adhesive for fixing the cover member, the glass may be broken at the time of removing the cover glass depending on the adhesive strength by the adhesive. In a case where the glass is broken, there is a possibility that scattered glass fragments adhere onto the pixels of the semiconductor chip, so that a defect such as an imaging defect occurs, for example.

Furthermore, according to the configuration in which the opening portion of the package main body portion is sealed by adhering and fixing the cover member, there are the following problems. That is, at the time of reflow installation on the set substrate or the like, deformation such as warpage of the package, breakage of the cover member, disconnection of the wire, or the like may occur due to an increase in internal pressure of the hollow package or a difference in linear expansion coefficient between constituent materials of the package.

An object of the present technology is to provide a semiconductor device, an electronic device, and a method for manufacturing the semiconductor device, in which in a state where a cover member is removed from a package main body portion, the cover member can be easily removed without leaving an adhesive for fixing the cover member, and entry of dust into a cavity can be suppressed without causing deformation of the package at a time of reflow.

### SOLUTIONS TO PROBLEMS

A semiconductor device according to the present technology includes: a semiconductor element; a package main body portion which includes a substrate portion on which the semiconductor element is installed, and a frame portion which is provided on the substrate portion so as to surround the semiconductor element and has an opening portion formed on an upper side; a cover member which is provided on the frame portion and closes the opening portion; and a covering portion which covers the package main body portion and the cover member so as to surround the package main body portion and the cover member from a side, thereby performing at least one of fixing the cover member to the frame portion or fixing a member forming the frame portion to a member forming the substrate portion.

According to another aspect of the semiconductor device according to the present technology, in the semiconductor device, the covering portion is formed by using a film member including a thermoplastic resin material which is heat-shrinkable.

According to another aspect of the semiconductor device according to the present technology, in the semiconductor device, the covering portion includes a covering main body portion which covers the package main body portion and the cover member from a side, an upper surface covering portion which covers a part of an upper surface side of the cover member, and a lower surface covering portion which covers a part of a lower surface side of the substrate portion.

According to another aspect of the semiconductor device according to the present technology, in the semiconductor device, the covering portion has at least one of a perforation for peeling at least a part of the covering portion from the package main body portion and the cover member or a cutout portion formed in an opening edge portion of the covering portion.

According to another aspect of the semiconductor device according to the present technology, in the semiconductor device, the covering portion includes an upper covering portion which covers an upper portion of the frame portion and the cover member, and a lower covering portion which is a portion lower than the upper covering portion, and a break line portion which facilitates separation between the upper covering portion and the lower covering portion is formed at a boundary between the upper covering portion and the lower covering portion.

According to another aspect of the semiconductor device according to the present technology, in the semiconductor device, the covering portion has a light shielding property.

According to another aspect of the semiconductor device according to the present technology, in the semiconductor device, a stepped portion for fitting the cover member is formed at a formation site of the opening portion in the frame portion.

According to another aspect of the semiconductor device according to the present technology, in the semiconductor device, the cover member is formed with a stepped portion for fitting to a formation site of the opening portion in the frame portion.

According to another aspect of the semiconductor device according to the present technology, in the semiconductor device, the cover member has an outline dimension larger than an outline of the frame portion in plan view, and includes an overhanging portion overhanging outward from the outline of the frame portion in plan view.

According to another aspect of the semiconductor device according to the present technology, in the semiconductor device, the frame portion is provided as a separate portion from the member forming the substrate portion, and a stepped portion for fitting the member forming the substrate portion is formed in the member forming the frame portion.

An electronic device according to the present technology includes a semiconductor device including: a semiconductor element; a package main body portion which includes a substrate portion on which the semiconductor element is installed, and a frame portion which is provided on the substrate portion so as to surround the semiconductor element and has an opening portion formed on an upper side; a cover member which is provided on the frame portion and closes the opening portion; and a covering portion which covers the package main body portion and the cover member so as to surround the package main body portion and the cover member from a side, thereby performing at least one of fixing the cover member to the frame portion or fixing a member forming the frame portion to a member forming the substrate portion.

An electronic device according to the present technology includes a semiconductor device including: a semiconductor element; a package main body portion which includes a substrate portion on which the semiconductor element is installed, and a frame portion which is provided on the substrate portion so as to surround the semiconductor element and has an opening portion formed on an upper side; and a covering portion which covers the package main body portion so as to surround the package main body portion from a side.

A method for manufacturing a semiconductor device according to the present technology includes: a step of setting a film member to a configuration including a semiconductor element, a package main body portion which includes a substrate portion on which the semiconductor element is installed, and a frame portion which is provided on the substrate portion so as to surround the semiconductor element and has an opening portion formed on an upper side, and a cover member which is provided on the frame portion so as to close the opening portion, so as to cover the configuration with a cylindrical film member including a thermoplastic resin material which is heat-shrinkable; and a step of heating and shrinking the film member to bring the film member into close contact with the configuration, covering the package main body portion and the cover member with the film member so as to surround the package main body portion and the cover member from a side, and performing at least one of fixing the cover member to the frame portion or fixing a member forming the frame portion to a member forming the substrate portion.

### BRIEF DESCRIPTION OF DRAWINGS

Fig. 1 is a side cross-sectional view of a configuration of a solid-state imaging device according to a first embodiment of the present technology.
Fig. 2 is a plan view of the configuration of the solid-state imaging device according to the first embodiment of the present technology.
Fig. 3 is a side view of the configuration of the solid-state imaging device according to the first embodiment of the present technology.
Fig. 4 is a bottom view of the configuration of the solid-state imaging device according to the first embodiment of the present technology.
Fig. 5 is an enlarged view of a portion C in Fig. 1.
Fig. 6 is a perspective view illustrating a heat-shrinkable tube according to the first embodiment of the present technology.
Fig. 7 is a diagram for describing a method for manufacturing the solid-state imaging device according to the first embodiment of the present technology.
Fig. 8 is a diagram for describing the method for manufacturing the solid-state imaging device according to the first embodiment of the present technology.
Fig. 9 is a diagram for describing a method for removing a cover glass of the solid-state imaging device according to the first embodiment of the present technology.
Fig. 10 is a diagram for describing functions and effects of the solid-state imaging device according to the first embodiment of the present technology.
Fig. 11 is a side cross-sectional view of a configuration of a first modification of the solid-state imaging device according to the first embodiment of the present technology.
Fig. 12 is a plan view of a configuration of a second modification of the solid-state imaging device according to the first embodiment of the present technology.
Fig. 13 is a plan view of a configuration of a third modification of the solid-state imaging device according to the first embodiment of the present technology.
Fig. 14 is a side view illustrating the configuration of the third modification of the solid-state imaging device according to the first embodiment of the present technology.
Fig. 15 is a perspective view illustrating a heat-shrinkable tube of the third modification of the solid-state imaging device according to the first embodiment of the present technology.
Fig. 16 is a diagram for describing a method for removing a cover glass of the third modification of the solid-state imaging device according to the first embodiment of the present technology.
Fig. 17 is a side view illustrating the configuration of a fourth modification of the solid-state imaging device according to the first embodiment of the present technology.
Fig. 18 is a perspective view illustrating a heat-shrinkable tube of the fourth modification of the solid-state imaging device according to the first embodiment of the present technology.
Fig. 19 is a diagram for describing a method for removing a cover glass of the fourth modification of the solid-state imaging device according to the first embodiment of the present technology.
Fig. 20 is a side cross-sectional view of a configuration of a solid-state imaging device according to a second embodiment of the present technology.
Fig. 21 is an enlarged view of a portion D in Fig. 20.
Fig. 22 is a diagram for describing a method for manufacturing the solid-state imaging device according to the second embodiment of the present technology.
Fig. 23 is a side cross-sectional view of a configuration of a modification of the solid-state imaging device according to the second embodiment of the present technology.
Fig. 24 is a side cross-sectional view of a configuration of a solid-state imaging device according to a third embodiment of the present technology.
Fig. 25 is an enlarged view of a portion E in Fig. 24.
Fig. 26 is a diagram for describing a method for manufacturing the solid-state imaging device according to the third embodiment of the present technology.
Fig. 27 is a diagram illustrating an example of a glass removal state of the solid-state imaging device according to the third embodiment of the present technology.
Fig. 28 is a block diagram illustrating a configuration example of an electronic device including the solid-state imaging device according to each embodiment of the present technology.

### MODE FOR CARRYING OUT THE INVENTION

In the present technology, a package main body portion and a cover member which closes an opening portion of the package main body portion are covered with a film member so as to surround the package main body portion and the cover member, whereby the members forming the package main body portion and the package main body portion are fixed to each other. With such a configuration, the present technology is intended to facilitate removal of the cover member without leaving an adhesive and to suppress deformation of a package during reflow and entry of dust into a cavity.

Hereinafter, modes for carrying out the present technology (hereinafter referred to as "embodiments") will be described with reference to the drawings. Note that the drawings are schematic, and dimensional ratios and the like of the respective parts do not necessarily match actual ones. Furthermore, it is needless to say that dimensional relationships and ratios are partly different between the drawings. In the embodiments to be described below, an imaging device (solid-state imaging device) including a solid-state imaging element that is an example of a semiconductor element will be described as an example of a semiconductor device. Note that the embodiments will be described in the following order.
1. Configuration example of solid-state imaging device according to first embodiment
2. Method for manufacturing solid-state imaging device according to first embodiment
3. Use example of solid-state imaging device according to first embodiment
4. Modification of solid-state imaging device according to first embodiment
5. Configuration example of solid-state imaging device according to second embodiment
6. Method for manufacturing solid-state imaging device according to second embodiment
7. Modification of solid-state imaging device according to second embodiment
8. Configuration example of solid-state imaging device according to third embodiment
9. Method for manufacturing solid-state imaging device according to third embodiment
10. Configuration example of electronic device

### <1. Configuration example of solid-state imaging device according to first embodiment>

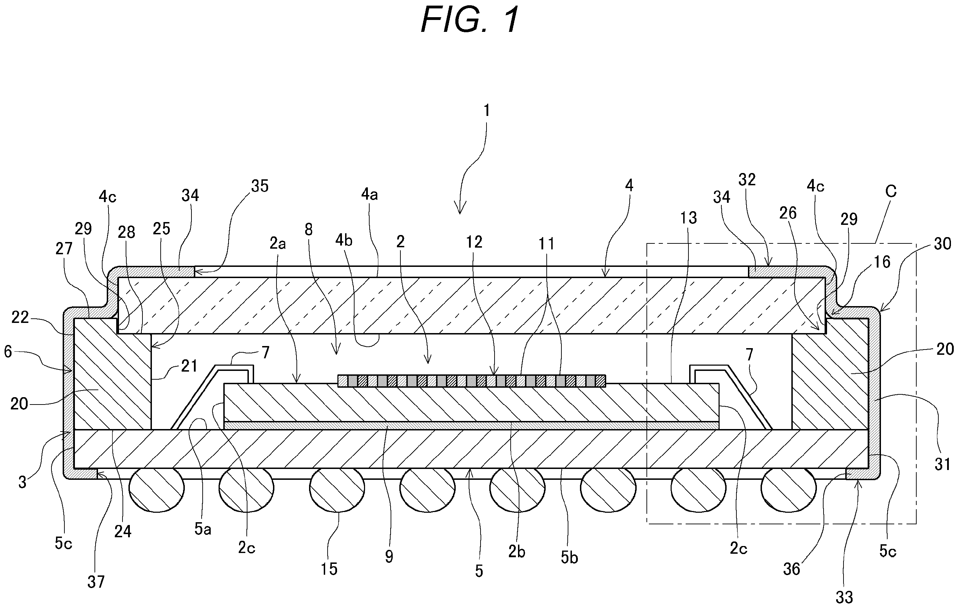

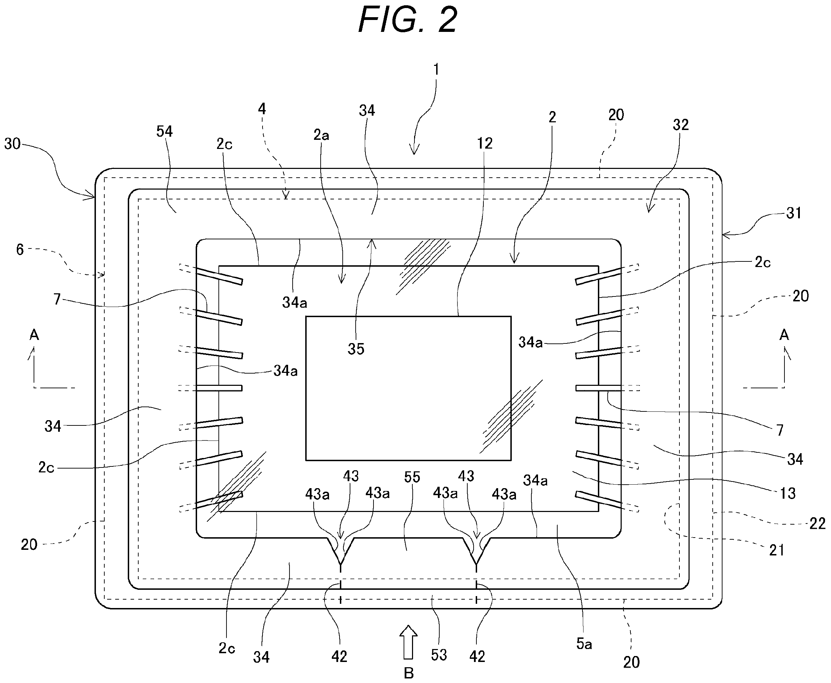

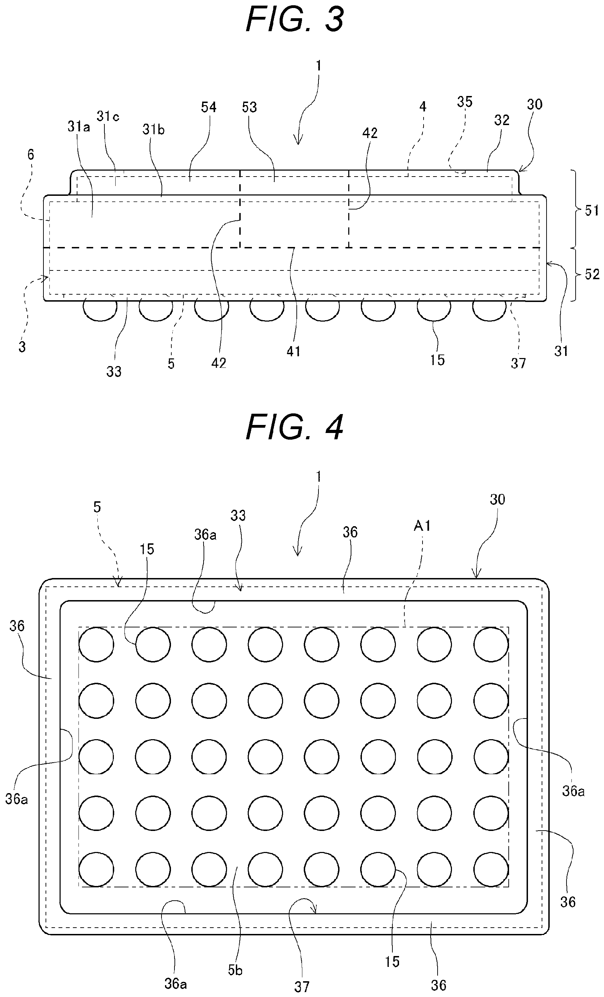

A configuration example of a solid-state imaging device according to a first embodiment of the present technology will be described with reference to Figs. 1 to 6. Note that an up-down direction in Fig. 1 refers to the up-down direction of a solid-state imaging device 1. Fig. 1 is a cross-sectional view taken along line A-A in Fig. 2. Fig. 3 is a B-direction arrow view in Fig. 2.

As illustrated in Figs. 1 and 2, the solid-state imaging device 1 includes an image sensor 2 as a solid-state imaging element, a package main body portion 3 in which the image sensor 2 is installed, and a cover glass 4 as a transparent cover member. The package main body portion 3 includes a substrate 5 and a frame 6. Note that, in Fig. 2, a part that can be seen through the cover glass 4 is indicated by a solid line.

The solid-state imaging device 1 has a hollow package structure obtained by covering an upper opening portion of the box-shaped package main body portion 3 having the image sensor 2 as a semiconductor chip installed therein with the cover glass 4. That is, the solid-state imaging device 1 has, as a package structure, a structure in which the cover glass 4 is mounted on the substrate 5 with the frame 6 interposed between the cover glass 4 and the substrate 5, the substrate 5 having the image sensor 2 installed thereon, and a cavity 8 as a hollow portion is formed around the image sensor 2.

The substrate 5 is an interposer substrate, and is a flat member having a rectangular plate-shaped outline. The substrate 5 has a front surface 5a that is one plate surface on which the image sensor 2 is installed, a back surface 5b that is the other plate surface on the opposite side from the front surface 5a, and side surfaces 5c provided on the four sides. The image sensor 2 is die-bonded to the front surface 5a of the substrate 5. The image sensor 2 is bonded to the front surface 5a of the substrate 5 with a die bonding material 9 including an insulating or conductive adhesive or the like. Note that a plate thickness direction of the substrate 5 coincides with the up-down direction of the solid-state imaging device 1, and the front surface 5a side and the back surface 5b side coincide with the upper side and the lower side, respectively.

The substrate 5 is, for example, an organic substrate using, as a base material, an organic material such as glass epoxy resin, which is a type of fiber-reinforced plastic, and is a circuit board on which a predetermined circuit pattern formed by using a metal material is formed. However, the substrate 5 may be, for example, another type of substrate such as a ceramic substrate formed using ceramics such as alumina (Al₂O₃) or aluminum nitride (AlN) silicon nitride (Si₃N₄) as a base material.

The image sensor 2 is a semiconductor element including a semiconductor substrate including silicon (Si) which is an example of a semiconductor. The image sensor 2 is a rectangular plate-shaped chip, a front surface 2a side which is one plate surface is a light receiving surface side, and the other plate surface on the opposite side is a back surface 2b. The image sensor 2 has side surfaces 2c provided on the four sides.

A plurality of light receiving elements (photoelectric conversion elements) is formed on the front surface 2a side of the image sensor 2. The image sensor 2 is a complementary metal oxide semiconductor (CMOS) image sensor. Note that the image sensor 2 may be another type of imaging element such as a charge coupled device (CCD) image sensor.

The image sensor 2 includes, on the front surface 2a side, a pixel region 12 that is a light receiving region in which a large number of pixels 11 are formed, and a peripheral region 13 that is a region around the pixel region 12. In the pixel region 12, the large number of pixels 11 are formed in a predetermined arrangement pattern such as a Bayer arrangement, and form a light receiving portion in the image sensor 2. A predetermined peripheral circuit is formed in the peripheral region 13. The pixels 11 each include a photodiode as a photoelectric converter having a photoelectric conversion function, and a plurality of pixel transistors.

On the front surface 2a side of the image sensor 2, a color filter and an on-chip lens are formed on the semiconductor substrate so as to correspond to each pixel 11 via an antireflection film, the antireflection film including an oxide film or the like, a planarization film including an organic material, and the like. The light incident on the on-chip lens is received by the photodiode via a color filter, a planarization film, and the like.

Note that the configuration of the image sensor 2 according to the present technology is not particularly limited. Examples of the configuration of the image sensor 2 include a front side illumination type in which the pixel region 12 is formed on the front surface side of the semiconductor substrate, a back side illumination type in which photodiodes and the like are arranged on the opposite side, and the back surface side of the semiconductor substrate serves as the light receiving surface side in order to improve light transmittance, and the like.

The substrate 5 and the image sensor 2 are electrically connected by a plurality of wires (bonding wires) 7 as connection members. The wires 7 are conductive wires and are thin metal wires including, for example, Au (gold), Cu (copper), Al (aluminum), or the like. Each wire 7 has one end connected to an electrode formed on the front surface 5a of the substrate 5, and has the other end connected to an electrode formed in the peripheral region 13 of the front surface 2a of the image sensor 2, and these electrodes are electrically connected to each other.

The plurality of wires 7 is provided on the basis of the number of electrodes of the substrate 5 or the like. In the example illustrated in Fig. 2, the plurality of wires 7 is provided on a pair of side portions, that is, the opposite sides, of the image sensor 2. However, the arrangement sites of the plurality of wires 7 are not particularly limited.

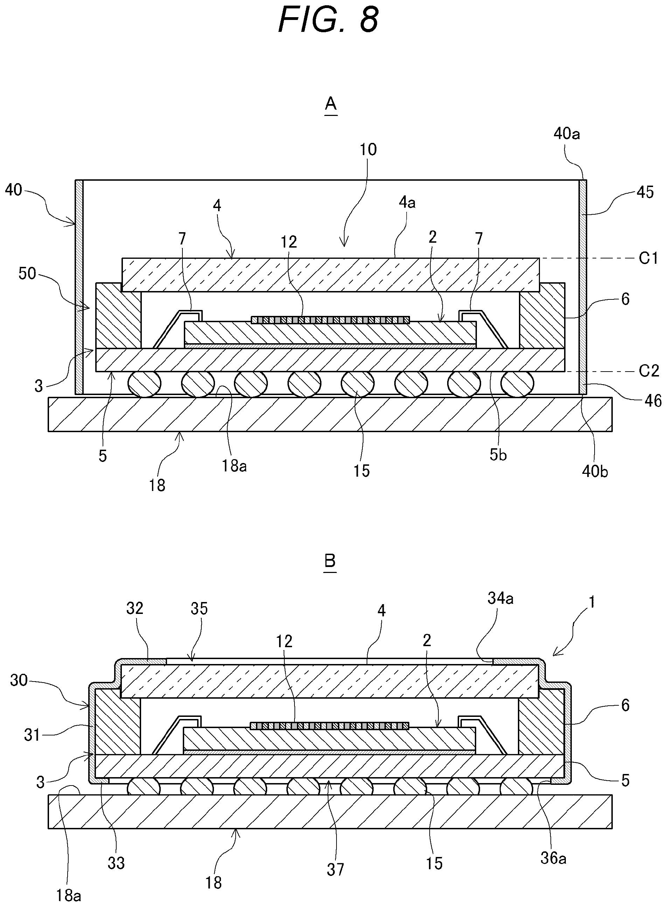

The electrode of the substrate 5 to which each wire 7 is connected is electrically connected to a plurality of terminal electrodes formed on the back surface 5b side of the substrate 5 via a predetermined wiring portion formed in the substrate 5. Each terminal electrode is provided with a solder ball 15. The solder balls 15 are two-dimensionally arranged in a lattice point shape along a rectangular outline of the image sensor 2 to form a ball grid array (BGA) (see Fig. 4). The solder ball 15 serves as a terminal for electrical connection to a set substrate 18 (see Fig. 8B) which is a circuit board on which the solid-state imaging device 1 is installed in an electronic device in which the solid-state imaging device 1 is mounted.

The frame 6 is a frame-shaped portion, is provided on the substrate 5 so as to surround the image sensor 2, and forms a peripheral wall portion on the substrate 5. The frame 6 includes wall portions 20 provided on the four sides in a rectangular shape in plan view corresponding to the rectangular (or square) shape of the substrate 5 in plan view, and the wall portions 20 form a frame shape. Each wall portion 20 has a substantially rectangular outline with the up-down direction as a longitudinal direction in side cross-sectional view (see Fig. 1). The wall portion 20 has an inner wall surface 21 that is a wall surface adjacent to the image sensor 2 and an outer wall surface 22 that is an outer wall surface on the opposite side from the inner wall surface 21.

The frame 6 is provided so as to make the outer wall surface 22 of each wall portion 20 flush with the side surface 5c of the substrate 5. Note that the frame 6 may be provided such that the outer wall surface 22 of each wall portion 20 is positioned inside or outside relative to the side surface 5c of the substrate 5. The frame 6 has a rectangular opening portion 25 on the upper side. The opening portion 25 is formed by the inner wall surfaces 21 provided on the four sides corresponding to the outline of the frame 6 in plan view. Thus, the opening portion 25 of the package main body portion 3 is formed by the frame 6.

A stepped portion 26 for fitting the cover glass 4 is formed at a site where the opening portion 25 is formed in the frame 6. The stepped portion 26 is formed along the outline of the frame 6 in plan view, and forms a stepped surface 28 toward a lower side with respect to an upper surface 27 having a rectangular frame shape in plan view and formed by upper end surfaces of the wall portions 20 provided on the four sides in the frame 6.

That is, the frame 6 includes, as the upper surface formed by the upper surfaces of the wall portions 20 provided on the four sides, the upper surface 27 forming a portion on the outer peripheral side in the rectangular frame-shaped outline in plan view, and the stepped surface 28 forming a portion on the inner peripheral side in the same outline in plan view and being one step lower than the upper surface 27. The stepped portion 26 includes an inner side surface 29 as a surface formed between the upper surface 27 and the stepped surface 28. The inner side surface 29 is formed as a vertical surface positioned outside the inner wall surface 21 and parallel to the inner wall surface 21 in each wall portion 20.

The upper surface 27 and the stepped surface 28 are each formed as a plane located on a predetermined virtual plane perpendicular to the up-down direction. In the frame 6, the stepped surface 28 serves as a glass support surface that supports the cover glass 4, and serves as an opening end surface of the opening portion 25. For example, the upper surface 27 and the stepped surface 28 are formed to have substantially the same dimension (a width of substantially 1/2 of the wall thickness of the wall portion 20) in the wall thickness direction of each wall portion 20. However, the dimensional ratio of the upper surface 27 and the stepped surface 28 in the wall thickness direction of the wall portion 20 is not particularly limited.

In the frame 6, the stepped portion 26 has an outline in plan view formed by the inner side surfaces 29 provided on the four sides, the outline being slightly larger than the outline of the cover glass 4 in plan view. The frame 6 supports the cover glass 4 in a state where the cover glass 4 is fitted to the stepped portion 26. The dimension of the inner side surface 29 in the up-down direction is, for example, about 1/4 to 1/2 of the thickness of the cover glass 4.

As described above, the frame 6 includes the wall portions 20 provided on the four sides that form the stepped surface 28 serving as the glass support surface in a rectangular frame shape in plan view. Furthermore, the frame 6 has the upper surface 27 and a lower surface 24 which is a surface opposite to the stepped surface 28.

The frame 6 is provided on the front surface 5a of the substrate 5 such that the lower surface 24 is positioned outside the electrode to which the wire 7 is connected without coming into contact with the wire 7 and the electrode.

The frame 6 is formed in a predetermined shape on the substrate 5 by injection molding using a mold. In injection molding for forming the frame 6, for example, for an integrated substrate assembly in which a plurality of substrate elements serving as the substrate 5 are continuous, a frame portion corresponding to each substrate element and including a portion serving as the frame 6 is formed in a lattice shape by injection molding. Then, a molded product in which the frame portion is formed on the integrated substrate by injection molding is divided by dicing or the like, whereby a configuration having the frame 6 on the substrate 5, that is, the package main body portion 3 is obtained.

The material of the frame 6 is, for example, a thermosetting resin containing silicon oxide as a main component or containing a filler such as alumina. As the resin material forming the frame 6, for example, thermosetting resins such as phenol-based resins, silicone-based resins, acryl-based resins, epoxy-based resins, urethane-based resins, silicon resins, and polyether amide-based resins, thermoplastic resins such as polyamideimide, polypropylene, and liquid crystal polymers, photosensitive resins such as UV-curable resins which are acryl-based resins, rubbers, and other known resin materials are used alone or in combination. Furthermore, the frame 6 may be a portion formed by using a resin material that is liquid at normal temperature by compression molding or the like.

Furthermore, the frame 6 is preferably formed by using a material having a light shielding property. Specifically, a black resin material containing a black pigment such as carbon black or titanium black is used as the material of the frame 6. Therefore, the frame 6 becomes a black portion, and the frame 6 can function as a light shielding portion.

As described above, the package main body portion 3 includes the substrate 5, which is a member forming a substrate portion on which the image sensor 2 is installed, and the frame 6, which is a member provided on the upper side of the substrate 5 so as to surround the image sensor 2 and forming a frame portion having the opening portion 25 formed on the upper side. As described above, in the package main body portion 3, the frame 6 that is a component separate from the substrate 5 forming the substrate portion forms the frame portion. Note that the package main body portion 3 may include an integrated member such as a box-shaped package substrate having an upper side as an open side.

The cover glass 4 is an example of a transparent member, is provided on the substrate 5 with the frame 6 interposed between the cover glass 4 and the substrate 5, and is positioned above the image sensor 2. The cover glass 4 has a rectangular plate-shaped outline and is larger in outline dimension than the image sensor 2. The cover glass 4 has an upper surface 4a that is an upper plate surface, a lower surface 4b that is a lower plate surface on the opposite side from the upper surface 4a and faces the image sensor 2, and side surfaces 4c provided on the four sides.

The cover glass 4 is provided on the frame 6 and closes the opening portion 25 of the package main body portion 3. The cover glass 4 is provided on the frame 6 so as to be parallel to and spaced apart from the image sensor 2 on the light receiving surface side of the image sensor 2. The cover glass 4 has an outline dimension larger than an opening dimension of the opening portion 25, and is provided to cover the entirety of the opening portion 25 from above.

The cover glass 4 is provided in a state of being placed and supported on the frame 6 without being fixed to the frame 6 with an adhesive or the like (in a non-fixed state). The cover glass 4 is supported on the frame 6 in a state of being fitted to the stepped portion 26 of the frame 6. In a state where the cover glass 4 is fitted to the stepped portion 26, the lower surface 4b serves as a contact surface with respect to the stepped surface 28, and the side surfaces 4c provided on the four sides serve as contact surfaces or facing surfaces with respect to the inner side surface 29.

The cover glass 4 is fitted to the stepped portion 26 so as to be easily removed from the frame 6. For example, the cover glass 4 may be provided in a state of being fitted to the stepped portion 26 with play. Thus, there may be a gap between the side surface 4c of the cover glass 4 and the inner side surface 29 of the frame 6.

Furthermore, in a state where the cover glass 4 is supported by the frame 6, a part of the frame 6 on the upper side in the thickness direction protrudes upward from the upper surface 27 of the frame 6. That is, the cover glass 4 has the lower portion of the side surface 4c in contact with or facing the inner side surface 29, and the upper portion of the side surface 4c exposed upward from the frame 6. The upper surface 27 of the frame 6 and the side surface 4c of the cover glass 4 form a stepped portion 16 formed by the frame 6 and the cover glass 4 outside the upper portion of the package.

The cover glass 4 transmits various kinds of light incident from the upper surface 4a side through an optical system such as a lens located above the cover glass 4. The light transmitted through the cover glass 4 reaches the light receiving surface of the image sensor 2 through the cavity 8. The cover glass 4 has a function of protecting the light receiving surface side of the image sensor 2. Note that, as the transparent member according to the present technology, for example, a plastic plate, a silicon plate, or the like may be used instead of the cover glass 4.

In the solid-state imaging device 1 having the above configuration, the light transmitted through the cover glass 4 passes through the cavity 8, and is received and detected by the light receiving elements constituting respective pixels 11 arranged in the pixel region 12 of the image sensor 2.

The solid-state imaging device 1 having the above configuration includes the cover film 30, which is a covering portion, as a configuration for fixing the cover glass 4 to the frame 6 forming the package main body portion 3. The cover film 30 covers the package main body portion 3 and the cover glass 4 so as to surround the package main body portion 3 and the cover glass 4 from the side, thereby fixing the cover glass 4 to the frame 6.

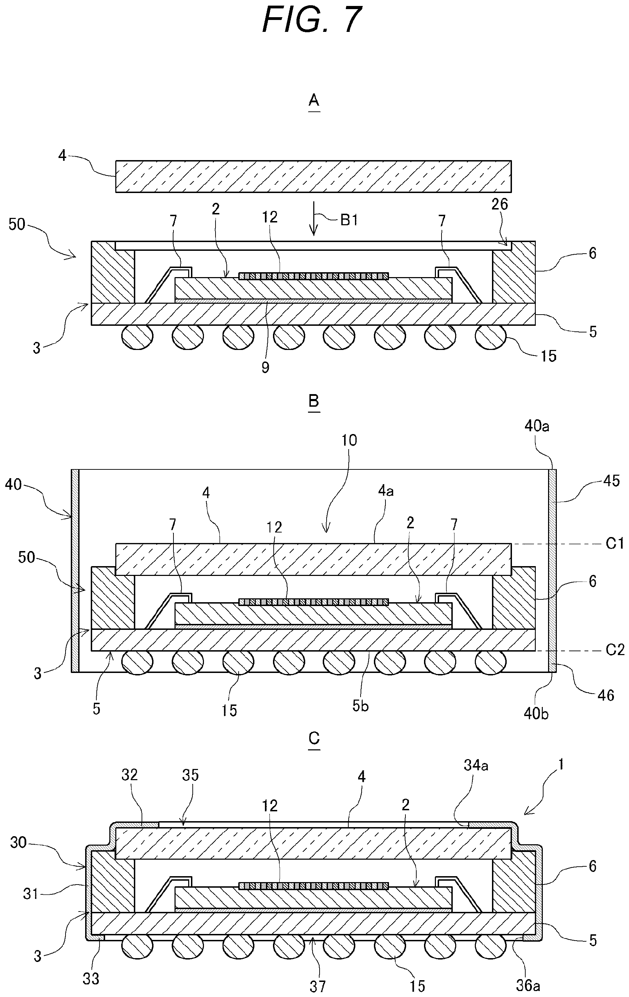

In the following description, a configuration to be covered with the cover film 30 in the solid-state imaging device 1 is referred to as a device main body portion 10 (see Fig. 7B). The device main body portion 10 includes the image sensor 2, the substrate 5 on which the image sensor 2 is installed, the package main body portion 3 which has the frame 6 provided on the upper side of the substrate 5 so as to surround the image sensor 2 and having the opening portion 25 formed on the upper side, and the cover glass 4 which is provided on the frame 6 so as to close the opening portion 25.

The cover film 30 surrounds the device main body portion 10 mainly from the side over the entire circumference in a state of being in tight contact with the device main body portion 10. The cover film 30 has a predetermined shape to hold and fix, to the frame 6, the cover glass 4 in a state of being supported by the frame 6.

The cover film 30 is formed by using a film member including a heat-shrinkable thermoplastic resin material. The cover film 30 is a film-shaped portion having a thickness of, for example, about several hundred micrometers.

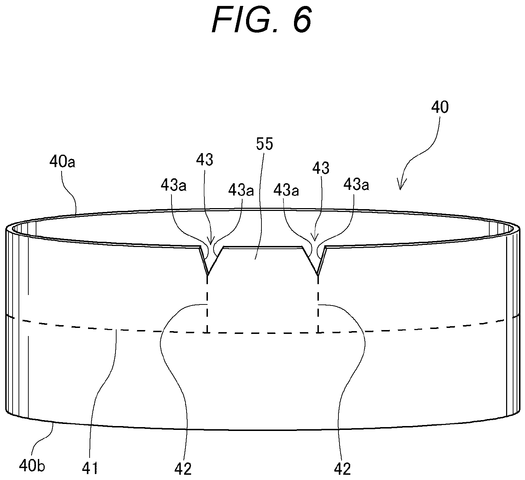

The film member forming the cover film 30 is a cylindrical heat-shrinkable tube 40 formed by using a film (see Fig. 6). That is, the cover film 30 is, for example, a portion formed by heating and shrinking the heat-shrinkable tube 40.

The heat-shrinkable tube 40 is, for example, a shape memory plastic tube which shrinks into a shape stored in advance by applying heat. The heat-shrinkable tube 40 is obtained by radiation-crosslinking a material such as a polyolefin such as polyethylene, a fluoropolymer, or an elastomer by electron beam irradiation or the like to impart heat shrinkage characteristics. The heat-shrinkable tube 40 is heated to shrink into a shape corresponding to the shape of the covering target.

As the heat-shrinkable tube 40 constituting the cover film 30, a known material can be used. The material of the cover film 30 is, for example, a soft flame-retardant fluorine elastomer resin, polyethylene, polypropylene, polyvinyl chloride, polystyrene, polyethylene terephthalate, or the like. Furthermore, as the heat-shrinkable tube 40, for example, a material having a shrinkage rate of 50% or more is used. Furthermore, as the heat-shrinkable tube 40, a material having a heat resistant temperature of preferably 200°C or higher, more preferably 250°C or higher is used.

The cover film 30 includes a covering main body portion 31, an upper surface covering portion 32, and a lower surface covering portion 33 as covering portions with respect to the device main body portion 10. Each of the covering main body portion 31, the upper surface covering portion 32, and the lower surface covering portion 33 is formed in an endless shape over the entire circumference of the device main body portion 10, has a covering shape along a rectangular outline of the device main body portion 10 in plan view, and covers each portion of the device main body portion 10.

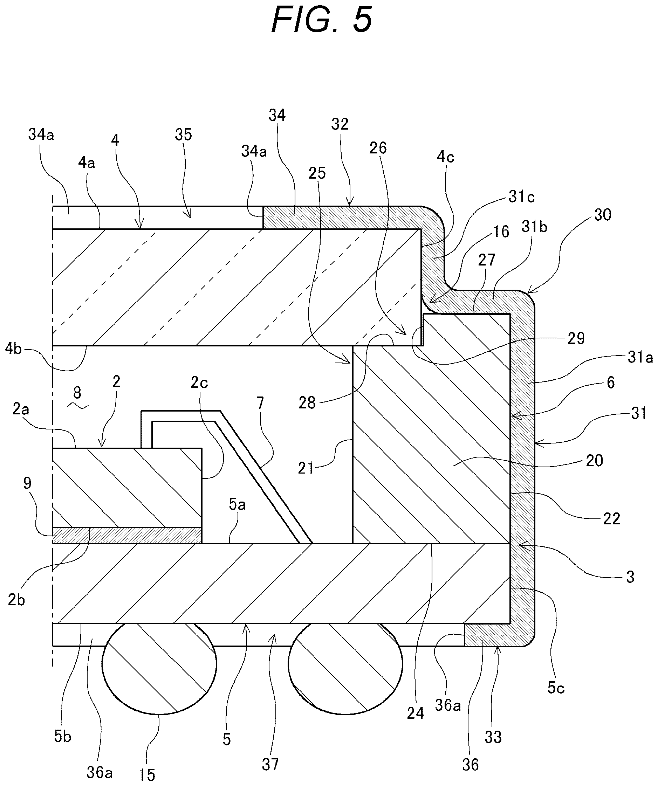

The covering main body portion 31 covers the package main body portion 3 and the cover glass 4 from the side. Specifically, the covering main body portion 31 has, in order from a lower side to an upper side, a lower vertical surface portion 31a which is a covering surface portion having a vertical shape, a horizontal surface portion 31b which is a covering surface portion having a horizontal shape, and an upper vertical surface portion 31c which is a covering surface portion having a vertical shape (see Fig. 5).

As illustrated in Fig. 5, the lower vertical surface portion 31a is a portion covering the side surface 5c of the substrate 5 and the outer wall surface 22 of the wall portion 20 of the frame 6 which form a flush surface. The horizontal surface portion 31b is a portion connected to the upper end of the lower vertical surface portion 31a, and is a portion covering the upper surface 27 of the frame 6. The upper vertical surface portion 31c is a portion connected to the inner edge end of the horizontal surface portion 31b, and is a portion covering an exposed portion of the side surface 4c of the cover glass 4 from the frame 6, that is, a portion of the side surface 4c above the upper surface 27.

Each of the combination of the lower vertical surface portion 31a and the horizontal surface portion 31b and the combination of the horizontal surface portion 31b and the upper vertical surface portion 31c forms a right-angled corner portion in side cross-sectional view by following the shape of the object to be covered (see Fig. 5). The stepped portion 16 formed by the frame 6 and the cover glass 4 in the upper portion of the package is covered with the horizontal surface portion 31b and the upper vertical surface portion 31c.

The upper surface covering portion 32 is a portion covering a part of the upper surface 4a side of the cover glass 4. Specifically, the upper surface covering portion 32 covers a portion on the outer peripheral side of the upper surface 4a of the cover glass 4. The upper surface covering portion 32 has four side portions 34 along the outline of the cover glass 4 in plan view. The four side portions 34 have a substantially constant width.

The upper surface covering portion 32 forms a rectangular upper surface opening portion 35 by the inner (the center side of the image sensor 2 in plan view) edge end portions of the four side portions 34. That is, the upper surface opening portion 35 is formed by the inner edge ends 34a of the four side portions 34.

The upper surface covering portion 32 is formed so as not to overlap the pixel region 12 of the image sensor 2 in plan view (see Fig. 2). That is, the upper surface covering portion 32 is formed such that the entire pixel region 12 falls within the opening range of the upper surface opening portion 35 in plan view. In the example illustrated in Fig. 2, the upper surface covering portion 32 is formed such that the entire image sensor 2 and a part of the plurality of wires 7 are within the range of the opening of the upper surface opening portion 35 in plan view. That is, the edge ends 34a provided on the four sides forming the upper surface opening portion 35 are positioned outside the side surface 2c of the image sensor 2 and inside the inner wall surface 21 of the wall portion 20 on the front surface 5a of the substrate 5 in plan view.

The lower surface covering portion 33 is a portion covering a part of the back surface 5b side, which the lower surface of the substrate 5. Specifically, the lower surface covering portion 33 covers the peripheral edge portion of the back surface 5b of the substrate 5. The lower surface covering portion 33 has four side portions 36 along the outline of the substrate 5 in plan view. The four side portions 36 have a substantially constant width.

The lower surface covering portion 33 forms a rectangular lower surface opening portion 37 by inner edge end portions of the four side portions 36. That is, the lower surface opening portion 37 is formed by the inner edge ends 36a of the four side portions 36.

The lower surface covering portion 33 is formed so as not to overlap a terminal formation region A1 which is a formation region of a plurality of solder balls 15 in bottom view (see Fig. 4). That is, the lower surface covering portion 33 is formed such that the entire terminal formation region A1 falls within the opening range of the lower surface opening portion 37 in plan view. The terminal formation region A1 has a region shape corresponding to the arrangement form of the plurality of solder balls 15. As illustrated in Fig. 4, in a configuration in which the plurality of solder balls 15 is arranged in a lattice point shape along the outline of the substrate 5 in the bottom view, the terminal formation region A1 is a rectangular region partitioned by a virtual straight line in point contact with the outer side with respect to each of the plurality of solder balls 15 located on the outermost peripheral side.

As illustrated in Figs. 2 and 3, the cover film 30 has perforations (41,42) for peeling a part of the cover film 30 from the device main body portion 10, and a cutout portion 43 formed in the opening edge portion of cover film 30.

The cover film 30 has, as perforations, a lateral perforation 41 which is a first break line portion and a longitudinal perforation 42 which is a second break line portion. The perforation formed in the cover film 30 is a dotted hole, and is a portion in which short slit-shaped hole portions are intermittently formed along a line. The perforation facilitates breakage of the cover film 30 along the perforation. Note that the length of a pitch between the hole portions forming the perforation, the size of the hole portion, and the like are not particularly limited.

The lateral perforation 41 is formed endlessly over the entire circumference of the cover film 30 along a plane perpendicular to the up-down direction so as to have a linear shape in the lateral direction (left-right direction) in the side view of the solid-state imaging device 1. The lateral perforation 41 is formed in the covering main body portion 31 of the cover film 30.

In the example illustrated in Fig. 3, the lateral perforation 41 is formed at a position substantially in the vertical center of the lower vertical surface portion 31a of the covering main body portion 31 in the up-down direction. The lateral perforation 41 is formed at a height position of a vertically intermediate portion of the frame 6 with respect to the device main body portion 10.

The cover film 30 is partitioned into an upper film portion 51 and a lower film portion 52 in the up-down direction by the lateral perforations 41. That is, the cover film 30 is divided into two parts, the upper film portion 51 and the lower film portion 52 by being separated along the lateral perforation 41. Each of the upper film portion 51 and the lower film portion 52 is a belt-shaped portion covering the entire circumference of the device main body portion 10.

The longitudinal perforation 42 is formed to have a linear shape in the longitudinal direction (up-down direction) in the side view of the solid-state imaging device 1. A pair of longitudinal perforations 42 is formed so as to be positioned in the vicinity of each other in the circumferential direction in the upper film portion 51 of the cover film 30. In the illustrated example, the pair of longitudinal perforations 42 is formed at a predetermined interval in the circumferential direction of the cover film 30 at the central portion of one side portion on the longitudinal side (the lower side portion in Fig. 2) among four side portions in a rectangular shape which is the outline of the upper film portion 51 in plan view.

The longitudinal perforation 42 is formed over the entire longitudinal direction with respect to the upper film portion 51. That is, as illustrated in Figs. 2 and 3, the longitudinal perforation 42 is formed in a range from the edge portion on the opening side of the upper surface covering portion 32 forming the upper surface opening portion 35 to the lateral perforation 41.

The upper film portion 51 of the cover film 30 is partitioned by the pair of longitudinal perforations 42 into an extraction portion 53 between the pair of longitudinal perforations 42 and a band portion 54 which is a portion other than the extraction portion 53 and forms the most part of the upper film portion 51. That is, the upper film portion 51 is divided into two parts, the extraction portion 53 and the band portion 54 by being separated along the pair of longitudinal perforations 42.

The cutout portion 43 is formed in the opening edge portion of the upper surface opening portion 35 of the cover film 30. The cutout portion 43 is formed at a position corresponding to the formation site of the longitudinal perforation 42 so as to be continuous with each of the pair of longitudinal perforations 42.

The cutout portion 43 is a V-shaped cutout recess formed by a pair of oblique side portions 43a, and is formed such that a top portion of the V shape, that is, an intersection portion of the pair of oblique side portions 43a is continued to an end portion on one side of the longitudinal perforation 42. In this manner, the cutout portion 43 is formed so as to be connected to the end portion of the longitudinal perforation 42 on the side opposite to the lateral perforation 41.

A projecting piece portion 55 having a relatively convex shape is formed by the pair of cutout portions 43 at the edge portion of on the upper surface opening portion 35 side of the upper surface covering portion 32 (see Fig. 2). The projecting piece portion 55 has a trapezoidal projecting shape by the adjacent oblique side portions 43a of the pair of cutout portions 43 and the edge end 34a of the side portion 34 between the adjacent oblique side portions 43a.

The pair of cutout portions 43 serves as a guide when the cover film 30 is broken by the longitudinal perforation 42, and breaking is performed by the pair of longitudinal perforations 42 with the cutout portion 43 as a trigger portion. Furthermore, the projecting piece portion 55 is used as a knob portion when the cover film 30 is broken by the longitudinal perforation 42.

Note that the cutout portion 43 is not limited to one having a V-shaped recess shape as the cutout shape. The recess shape of the cutout portion 43 may be, for example, a shape along each shape such as a rectangular shape, a U-shape, or an arc shape. Furthermore, the cover film 30 according to the present embodiment has both the perforations (41, 42) and the cutout portion 43, but is only required to have a configuration having at least one of the perforations (41, 42) and the cutout portion 43.

The cover film 30 having the above-described configuration includes an upper film portion 51 as an upper covering portion which covers the upper portion of the frame 6 and the cover glass 4 from the side, and a lower film portion 52 as a lower covering portion which is a portion lower than the upper film portion 51. The lower film portion 52 is a portion covering the lower portion of the frame 6 and the substrate 5 from the side. Then, at a boundary between the upper film portion 51 and the lower film portion 52, the lateral perforation 41 is formed as a break line portion which facilitates separation between the upper film portion 51 and the lower film portion 52.

Furthermore, the cover film 30 is provided as a portion having a light shielding property. Specifically, for example, a black resin material containing a black pigment such as carbon black or titanium black is used as the material of the heat-shrinkable tube 40 forming the cover film 30. Therefore, the cover film 30 becomes a black portion, and the cover film 30 can function as a light shielding portion. Note that the heat-shrinkable tube 40 may be subjected to processing such as coating or printing to impart a light shielding property to the cover film 30.

### <2. Method for manufacturing solid-state imaging device according to first embodiment>

An example of a method for manufacturing the solid-state imaging device 1 according to the first embodiment of the present technology will be described with reference to Figs. 7 and 8.

First, as illustrated in Fig. 7A, a step of manufacturing, a configuration on which the cover glass 4 is mounted, a sensor installation package substrate 50 which is a configuration including the substrate 5 on which the image sensor 2 is installed and the frame 6 is performed.

In the step of manufacturing the sensor installation package substrate 50, first, the frame 6 is formed on the substrate 5 by injection molding or the like, so that the package main body portion 3 is manufactured. Next, for the package main body portion 3, the image sensor 2 is die-bonded onto the substrate 5 by the die bonding material 9. Thereafter, wire bonding is performed in which the substrate 5 and the image sensor 2 are connected by a plurality of wires 7 and electrically connected to each other. Furthermore, a step of providing a plurality of solder balls 15 on the back surface 5b side of the substrate 5 is performed. Through these steps, the sensor installation package substrate 50 is obtained.

Next, as illustrated in Fig. 7A, a step of installing the cover glass 4 on the sensor installation package substrate 50 is performed. The cover glass 4 is prepared by cutting a glass plate having a predetermined shape into a rectangular shape by dicing.

The cover glass 4 is installed on the frame 6 so as to be fitted to the stepped portion 26 (see an arrow B1). Therefore, the device main body portion 10 having a configuration in which the cover glass 4 is set on the sensor installation package substrate 50 is obtained (see Fig. 7B).

Next, as illustrated in Fig. 7B, a step of setting the heat-shrinkable tube 40 with respect to the device main body portion 10 so as to surround the device main body portion 10 with the heat-shrinkable tube 40 including a heat-shrinkable thermoplastic resin material is performed.

The heat-shrinkable tube 40 has a cylindrical outline with both upper and lower sides open, and the entire device main body portion 10 or substantially the entire device main body portion 10 is positioned inside the heat-shrinkable tube. The heat-shrinkable tube 40 surrounds the outer periphery of the device main body portion 10 and covers the device main body portion 10 from the side.

The device main body portion 10 and the heat-shrinkable tube 40 are held in a predetermined positional relationship by being supported by a jig (not illustrated) or the like. For example, the heat-shrinkable tube 40 is set with respect to the device main body portion 10 such that the cylindrical axis center of the heat-shrinkable tube matches the planar center of the device main body portion 10.

The length (dimension in the vertical direction) and the tube diameter of the heat-shrinkable tube 40, and the position of the heat-shrinkable tube 40 in the up-down direction with respect to the device main body portion 10 are adjusted on the basis of the shrinkage rate of the heat-shrinkable tube 40 and the like such that the upper surface covering portion 32 and the lower surface covering portion 33 of the cover film 30 are formed in a predetermined region.

That is, as illustrated in Fig. 7B, the heat-shrinkable tube 40 has an upper protruding portion 45 in which the upper portion is located above a height position C1 of the upper surface 4a of the cover glass 4 in relation to the device main body portion 10. The upper protruding portion 45 includes a portion serving as the upper surface covering portion 32 of the cover film 30. The length of the upper protruding portion 45 is adjusted so as to form the upper surface covering portion 32 that does not overlap the pixel region 12 of the image sensor 2 in plan view in consideration of the shrinkage rate of the heat-shrinkable tube 40 and the like (see Fig. 2). An upper opening end surface 40a of the heat-shrinkable tube 40 serves as an edge end 34a forming the upper surface opening portion 35 in the cover film 30.

Furthermore, the heat-shrinkable tube 40 has a lower protruding portion 46 in which the lower portion is located below a height position C2 of the back surface 5b of the substrate 5 in relation to the device main body portion 10. The lower protruding portion 46 includes a portion serving as the lower surface covering portion 33 of the cover film 30. The length of the lower protruding portion 46 is adjusted so as to form the lower surface covering portion 33 that does not overlap the terminal formation region A1 of the substrate 5 in bottom view in consideration of the shrinkage rate of the heat-shrinkable tube 40 and the like (see Fig. 4). A lower opening end surface 40b of the heat-shrinkable tube 40 serves as an edge end 36a forming the lower surface opening portion 37 in the cover film 30.

Then, as illustrated in Fig. 7C, a step of forming the cover film 30 by heat-shrinking the heat-shrinkable tube 40 is performed. This step is a step of heating and shrinking the heat-shrinkable tube 40 to bring the heat-shrinkable tube 40 into close contact with the device main body portion 10, covering the package main body portion 3 and the cover glass 4 with the heat-shrinkable tube 40 so as to surround the package main body portion 3 and the cover glass 4 from the side, and fixing the cover glass 4 to the frame 6.

The heat shrinkage of the heat-shrinkable tube 40 is performed by using a predetermined heating method such as an atmosphere heat treatment by a heating furnace or the like or a heat treatment by a heating device. The heat-shrinkable tube 40 is heated to be shrunk into a shape matching the shape of the device main body portion 10 to be covered. Therefore, the cover film 30 having the covering main body portion 31, the upper surface covering portion 32, and the lower surface covering portion 33 is formed.

Through the manufacturing step as described above, the solid-state imaging device 1 is obtained. Note that the step of heating and shrinking the heat-shrinkable tube 40 may also serve as the step of reflow-installing of the solid-state imaging device 1.

In this case, as illustrated in Fig. 8A, in the step of setting the heat-shrinkable tube 40 to the device main body portion 10, the set substrate 18, which is a circuit board having a predetermined circuit structure, is set to the device main body portion 10 together with the heat-shrinkable tube 40. The device main body portion 10 is set in a state of being placed on the front surface 18a side of the set substrate 18.

Then, as illustrated in Fig. 8B, the device main body portion 10 and the heat-shrinkable tube 40 are heated to a temperature of, for example, about 200°C by a reflow device such as a reflow furnace, whereby the heat-shrinkable tube 40 is heated and shrunk, and reflow-installing is performed by a plurality of solder balls 15. Therefore, the cover film 30 is formed by the heat-shrinkable tube 40 in close contact with the device main body portion 10, and the substrate 5 is electrically connected to the set substrate 18 by the plurality of solder balls 15. That is, the solid-state imaging device 1 including the cover film 30 that fixedly holds the cover glass 4 on the frame 6 is obtained, and a configuration in which the solid-state imaging device 1 is installed on the set substrate 18 is obtained.

In the above-described example, the heat-shrinkable tube 40 is used as the film member forming the cover film 30, but the film member may be, for example, a cylindrical film obtained by bonding and connecting edge portions of the rectangular film on opposite sides by adhesion, heat welding, or the like. In this case, a bonding portion in which the films overlap each other is formed at a part of the cylindrical film member in the circumferential direction.

### <3. Use example of solid-state imaging device according to first embodiment>

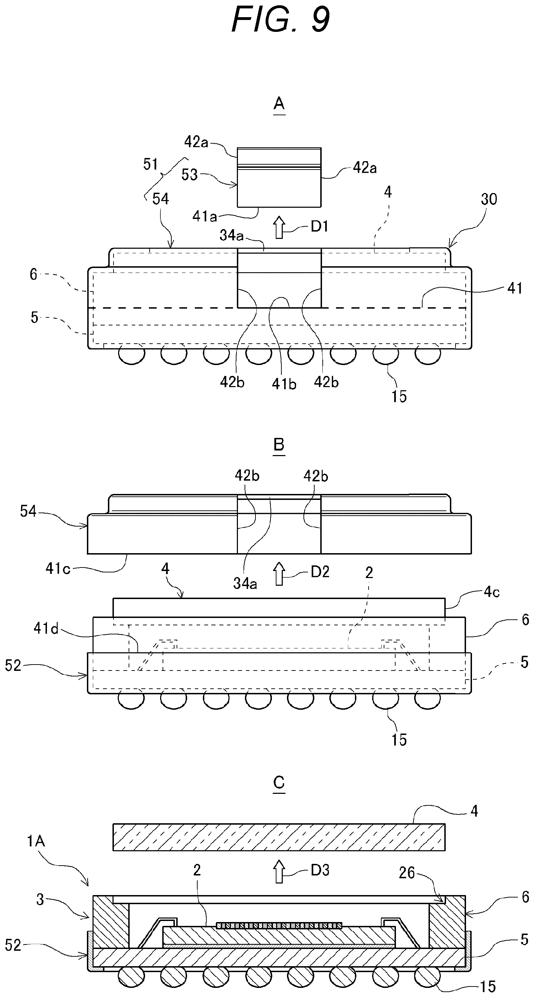

As a use example of the solid-state imaging device 1 according to the first embodiment of the present technology, a method of handling and removing the cover glass 4 will be described with reference to Fig. 9. Note that Figs. 9A and 9B are side views, and Fig. 9C is a side cross-sectional view.

In a state where the cover glass 4 is fixed by the cover film 30, the solid-state imaging device 1 receives an inspection for imaging by the image sensor 2, is transported as a product, or is installed on a set substrate. Furthermore, the cover glass 4 is, for example, a member for preventing foreign matter from being mixed into the package of the solid-state imaging device 1.

On the other hand, for example, when the solid-state imaging device 1 is incorporated into a predetermined set structure constituting an electronic device such as a camera device, for a camera application that does not require the cover glass 4, the cover glass 4 is removed from the package main body portion 3. That is, as one mode of use of the solid-state imaging device 1, the solid-state imaging device 1 is used with the cover glass 4 once attached to the package main body portion 3 removed.

When the cover glass 4 is removed, the upper film portion 51 of the cover film 30 is stripped off from the solid-state imaging device 1 in order to release the fixed state of the cover glass 4 by the cover film 30.

Specifically, first, as illustrated in Fig. 9A, the extraction portion 53 of the cover film 30 is stripped off (see arrow D1). In the stripping of the extraction portion 53, the projecting piece portion 55 (see Fig. 2) is used as a knob portion, and the extraction portion 53 is separated from the band portion 54 and the lower film portion 52 by using, as a break line, a portion on the lower side of the extraction portion 53 out of the left and right longitudinal perforations 42 and the lateral perforation 41. By stripping off the extraction portion 53, the side portions 42a and 42b after breakage by the longitudinal perforation 42 and the side portions 41a and 41b after breakage by a part of the lateral perforation 41 are generated in the extraction portion 53 and the band portion 54, respectively.

Next, as illustrated in Fig. 9B, the band portion 54 of the cover film 30 is stripped off (see arrow D2). In the stripping of the band portion 54, the band portion 54 is separated from the lower film portion 52 with the lateral perforation 41 as a break line. By stripping off the extraction portion 53 and the band portion 54, the upper film portion 51 of the cover film 30 is stripped off. By stripping off the band portion 54, the side portions 41c and 41d after being broken by a part of the lateral perforation 41 are generated in each of the band portion 54 and the lower film portion 52.

As illustrated in Fig. 9C, when the upper film portion 51 is stripped off, the lower film portion 52 remains, and the upper portion of the frame 6 and the cover glass 4 are exposed. Since the cover glass 4 is fitted to the stepped portion 26 so as to be easily removable from the frame 6, the cover glass 4 is removed from the frame 6 by lifting the cover glass 4 with respect to the 6 (see an arrow D3).

As described above, the cover glass 4 is removed from the solid-state imaging device 1. Therefore, as illustrated in Fig. 9C, a solid-state imaging device 1A is obtained which includes the image sensor 2, the package main body portion 3, and the lower film portion 52 as a covering portion covering the lower portions of the substrate 5 and the frame 6 forming the lower portion of the package main body portion 3 so as to surround the lower portions from the side.

Note that the cover glass 4 is removed, for example, in a state where the solid-state imaging device 1 is reflow-installed on the set substrate 18 (see Fig. 8B). Furthermore, the cover glass 4 is removed in accordance with the application of the solid-state imaging device 1 or the like, and the solid-state imaging device 1 is used in a state where the cover glass 4 is fixed by the cover film 30 in accordance with the application or the like.

According to the solid-state imaging device 1 according to the present embodiment as described above, in a state where the cover glass 4 is removed from the package main body portion 3, the cover glass 4 can be easily removed without leaving an adhesive for fixing the cover glass 4, and entry of dust into the cavity 8 can be suppressed without causing deformation of the package at the time of reflow.

In the solid-state imaging device 1, the cover glass 4 is held and fixed to the package main body portion 3 by the cover film 30 covering the device main body portion 10. According to such a configuration, by peeling off the cover film 30, the cover glass 4 can be easily removed without using a tool, an instrument, or the like. Furthermore, since an adhesive is not used for fixing the cover glass 4, it is possible to prevent breakage of the cover glass 4 due to forced peeling of the cover glass 4 or the like. Furthermore, the cover glass 4 removed from the package main body portion 3 is not adhered with an adhesive or the like, so that the cover glass 4 can be reused as it is.

Furthermore, since no adhesive is applied to the stepped surface 28 which is the glass support surface of the frame 6 on which the cover glass 4 is placed and supported, there is no possibility that the adhesive remains as a residue on the frame 6 with the cover glass 4 removed, and the upper surface of the frame 6 can be kept clean. It is therefore possible for the solid-state imaging device 1A without glass to use the upper surface of the frame 6 as, for example, a joint surface to be joined to a casing or the like of the set structure, a guide plane used in tilt adjustment (adjustment of the tilt of the imaging surface) when the solid-state imaging device 1A is attached to the set structure, or a joint surface of a new component to be joined to the package main body portion 3.

Furthermore, since no adhesive remains on the upper surface of the frame 6, it is possible to prevent an adhesive from adhering to the image sensor 2 inside the package as dust or from reflecting incident light to generate flare. Therefore, the performance of the image sensor 2 can be secured.

Furthermore, according to the fixing structure of the cover glass 4 according to the present embodiment, when the solid-state imaging device 1 is reflow-installed on the set substrate, a material having heat resistance to heat during reflow is used as a material of the cover film 30, so that reflow-installing can be performed in a state where the cover glass 4 is held and fixed by the cover film 30. This allows the image sensor 2 to be covered with the cover glass 4 during reflow soldering, so that it is possible to prevent the image sensor 2 from being contaminated.

Furthermore, the fixing structure of the cover glass 4 according to the present embodiment prevents the opening portion 25 of the frame 6 from being hermetically sealed by the cover glass 4, so that air can be passed through a gap between the frame 6 and the cover glass 4 or a gap between the device main body portion 10 and the cover film 30 at the time of reflow or the like in installing the solid-state imaging device 1 on the set substrate. Therefore, it is possible to suppress an increase in stress accompanying an increase in the internal pressure of the cavity 8 of the package, and thus, it is possible to suppress deformation such as warpage of the package accompanying reflow-installing, breakage of the cover glass 4, disconnection of the wire 7, and the like.

Furthermore, since an adhesive is not used for fixing the cover glass 4, positional displacement of the cover glass 4 with respect to the frame 6 is allowed. Therefore, for example, at the time of reflow-installing of the solid-state imaging device 1, it is possible to suppress deformation of the package due to a difference in linear expansion coefficients of the constituent materials of the package.

Furthermore, according to the fixing structure of the cover glass 4 according to the present embodiment, the package is covered from the outside by the cover film 30, so that the mating portion between the members in the device main body portion 10 can be covered from the outside. Therefore, it is possible to suppress dust from entering the cavity 8.

Furthermore, since the cover glass 4 is configured to be fitted and supported with respect to the frame 6 by the stepped portion 26 without using an adhesive, the cover glass 4 can be easily attached to the frame 6. That is, according to the fixing structure of the cover glass 4 according to the present embodiment, the cover glass 4 can be easily attached and detached.

Furthermore, the cover film 30 is formed by using the heat-shrinkable tube 40. According to such a configuration, the cover film 30 along the outline of the device main body portion 10 can be easily formed as the covering portion for fixing the cover glass 4 to the frame 6.

Furthermore, the cover film 30 includes the covering main body portion 31, the upper surface covering portion 32, and the lower surface covering portion 33. According to such a configuration, at the time of heat shrinkage of the heat-shrinkable tube 40, the portions serving as the upper surface covering portion 32 and the lower surface covering portion 33 can be used as the locking portions with respect to the device main body portion 10, and the heat-shrinkable tube 40 can be suppressed from being displaced. Therefore, it is easy to control the site covered with the cover film 30, and it is possible to reliably cover a desired portion with respect to the device main body portion 10.

Furthermore, the cover film 30 also includes the lateral perforations 41 and the longitudinal perforation 42 for facilitating peeling of the cover film 30, and the cutout portion 43. According to such a configuration, the position and direction of breakage of the cover film 30 can be guided, and the cover film 30 can be easily peeled off. Furthermore, a remaining site in a case where a part of the cover film 30 remains on the device main body portion 10 side can be controlled by the formation site of the perforation and the cutout portion 43, and thus, it is possible to obtain excellent workability for the peeling work of the cover film 30 when the cover glass 4 is removed.

Furthermore, the cover film 30 has the upper film portion 51 and the lower film portion 52 as portions to be separated by the lateral perforations 41. According to such a configuration, the upper film portion 51 which is a portion necessary for removing the cover glass 4 can be accurately and reliably stripped off from the cover film 30. Therefore, excellent workability can be obtained for the peeling work of the cover film 30 when the cover glass 4 is removed.

Furthermore, the lower film portion 52 which is a part of the cover film 30 can remain in the solid-state imaging device 1A in a state where the cover glass 4 is removed. Therefore, the lower film portion 52 can be used as a protective material against external impact of the package or a covering material against dust entering the cavity 8.

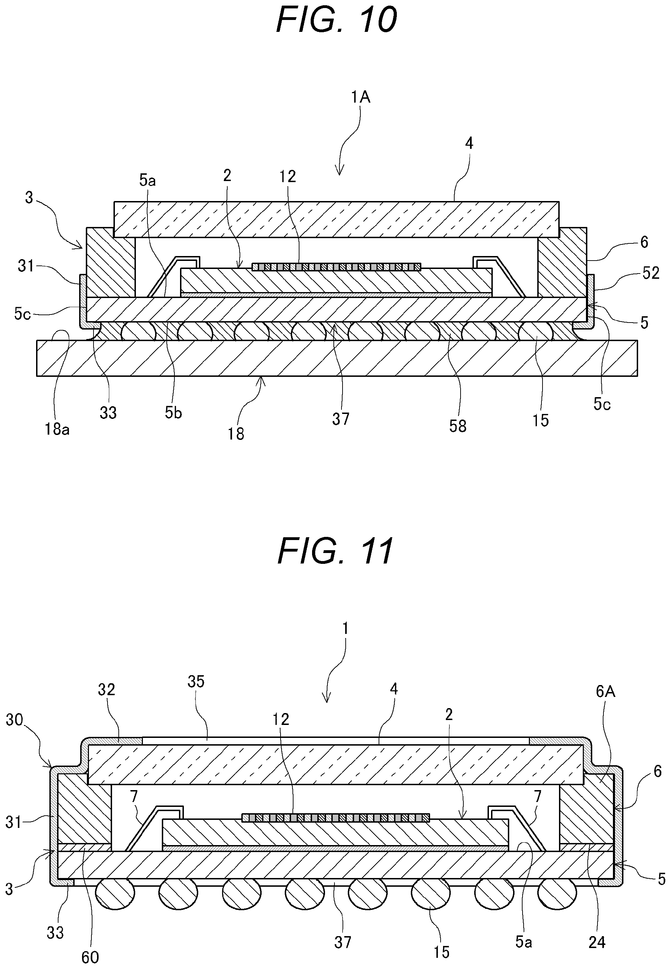

Furthermore, according to the configuration in which the lower film portion 52 remains on the device main body portion 10 side, the following operational effects can be obtained. For example, as illustrated in Fig. 10, there is a case where an underfill portion 58 is provided between the substrate 5 of the solid-state imaging device 1 and the set substrate 18 in order to improve connection reliability of the solid-state imaging device 1 with respect to the set substrate 18.

The underfill portion 58 is a liquid curable resin portion formed by curing a paste-shaped or liquid resin, and is formed by, for example, flowing a liquid resin having a relatively low viscosity by using a capillary phenomenon. The material (underfill material) forming the underfill portion 58 is, for example, a thermosetting resin such as an epoxy-based resin or a material in which a filler containing silicon oxide as a main component is dispersed in a thermosetting resin. The underfill portion 58 is formed so as to fill a space between the substrate 5 and the set substrate 18 in a state of covering the whole or a part of the plurality of solder balls 15 provided in an array shape between the substrate 5 and the set substrate 18.

In the configuration in which the underfill portion 58 is provided as described above, the lower film portion 52 can suppress the underfill material from protruding to the region outside the substrate 5 on the front surface 18a of the set substrate 18. That is, since the stepped portion with respect to the back surface 5b can be formed at the peripheral edge portion of the back surface 5b of the substrate 5 by the lower surface covering portion 33 of the lower film portion 52, it is possible to restrict the underfill material from flowing and spreading to the outside of the outline of the substrate 5. Therefore, the area on the front surface 18a of the set substrate 18 can be effectively used.

Furthermore, in the configuration in which the underfill portion 58 is provided, the lower film portion 52 can protect the substrate 5 from the underfill material crawling up on the side surface 5c of the substrate 5. Specifically, since the lower film portion 52 can prevent the underfill material from adhering to the side surface 5c of the substrate 5, for example, in a case where the underfill material adheres to the side surface 5c of the substrate 5, it is possible to prevent a crack or the like of the substrate 5 caused by a linear expansion difference or the like between the underfill material and the substrate 5.

Furthermore, the cover film 30 is a black portion and has a light shielding property. According to such a configuration, light to be transmitted through the cover glass 4 can be restricted by partially covering the upper surface 4a of the cover glass 4 with the upper surface covering portion 32. Therefore, for example, it is possible to suppress the occurrence of flare due to the light transmitted through the cover glass 4 being reflected by the wire 7 or the like and entering the light receiving unit of the image sensor 2.

Furthermore, the stepped portion 26 for fitting the cover glass 4 is formed at a site where the opening portion 25 of the frame 6 is formed. According to such a configuration, the cover glass 4 can be positioned with respect to the frame 6, so that the positional displacement of the cover glass 4 held by the frame 6 can be prevented by the cover film 30 without using an adhesive.

Furthermore, as a method for manufacturing the solid-state imaging device 1, a method is used which includes a step of using the heat-shrinkable tube 40 and setting the heat-shrinkable tube 40 so as to surround the device main body portion 10, and a step of forming the cover film 30 by heating and shrinking the heat-shrinkable tube 40. According to such a method for manufacturing, the cover film 30 for holding and fixing the cover glass 4 to the frame 6 can be easily provided, and the solid-state imaging device 1 can be easily manufactured.

### <4. Modification of solid-state imaging device according to first embodiment>

A modification of a solid-state imaging device 1 according to the first embodiment of the present technology will be described.

### (First modification)

A first modification is a modification of the substrate 5 and the frame 6. In the first modification, the substrate 5 is a ceramic substrate formed using ceramics as a base material. Furthermore, as illustrated in Fig. 11, the frame 6 is formed by using a frame-shaped frame member 6A separate from the substrate 5.

The frame member 6A is provided on the front surface 5a of the substrate 5 such that the lower surface 24 is positioned outside the electrode to which the wire 7 is connected without coming into contact with the wire 7 and the electrode. The frame member 6A is fixed on the front surface 5a of the substrate 5 with an adhesive 60 such as an epoxy resin-based adhesive or an acrylic resin-based adhesive.

The frame member 6A is an integral member including, for example, a resin material such as an epoxy resin, a metal material such as stainless steel or copper (Cu), or ceramics. Furthermore, from the viewpoint of preventing reflection of light, for example, a low-reflection black resin material obtained by adding a black pigment such as carbon black or titanium black to resin such as a liquid crystal polymer or polyetheretherketone (PEEK) is used, and the frame member 6A is manufactured by a known method such as injection molding or transfer molding. Note that the frame member 6A is not limited to, for example, a configuration that includes only one kind of material, and may have a composite structure having a portion including a metal material and a portion including a resin material.

In the configuration of the first modification, in the step of manufacturing the sensor installation package substrate 50 (see Fig. 7A), a frame mounting step of attaching the frame member 6A on the substrate 5 is performed. In the frame mounting step, after the adhesive 60 is applied to a predetermined site of the front surface 5a of the substrate 5, the frame member 6A is placed on the substrate 5, and the frame member 6A is fixed to the substrate 5. The adhesive 60 is applied over the entire circumference in a frame shape along the outline of the substrate 5 so as to conform to the shape of the frame member 6A in plan view. The adhesive 60 may be applied to the frame member 6A side.

As a result of this process, the package main body portion 3 having a configuration where the frame 6 is set on the substrate 5 is obtained. Note that the step of fixing the frame member 6A to the substrate 5 may be performed after the step of die bonding of the image sensor 2 to the substrate 5 and wire bonding of the wire 7, or may be performed before the step of die bonding and wire bonding.

According to the configuration of the first modification, when the frame 6 is provided on the substrate 5, the frame 6 can be provided on the substrate 5 without performing injection molding using a mold.

### (Second modification)

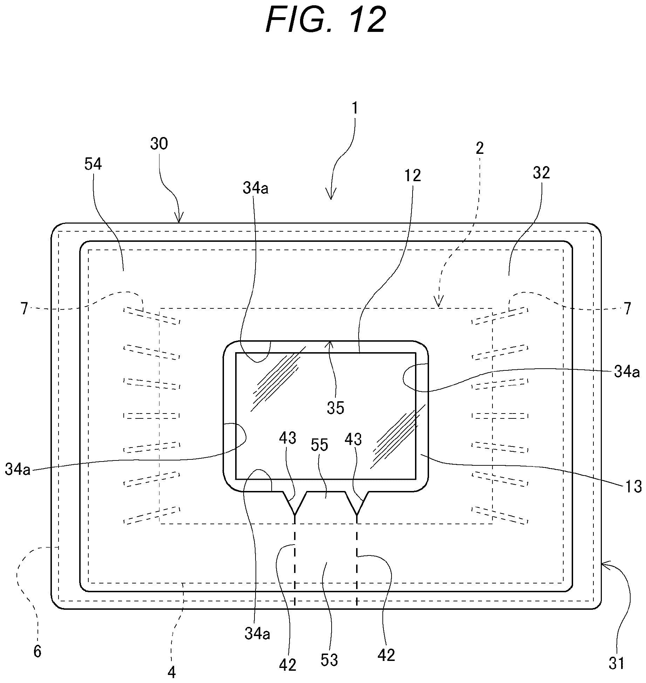

A second modification is a modification of the formation mode of the cover film 30. In the second modification, as illustrated in Fig. 12, the upper surface covering portion 32 of the cover film 30 is formed in a range up to a position near the pixel region 12 of the image sensor 2 in plan view.

As illustrated in Fig. 12, in the second modification, the upper surface covering portion 32 is formed such that the entire pixel region 12 and a portion of the peripheral region 13 in the vicinity of the periphery of the pixel region 12 fall within the range of the opening of the upper surface opening portion 35 in plan view. That is, in plan view, the edge ends 34a provided on the four sides forming the upper surface opening portion 35 are positioned on the peripheral region 13 of the image sensor 2 and on the inner side (on the pixel region 12 side) of the connection portion of the plurality of wires 7 with respect to the image sensor 2.

According to the configuration of the second modification, most of the periphery of the upper surface 4a of the cover glass 4 can be covered with the cover film 30 functioning as a light shielding film, so that occurrence of flare can be effectively suppressed.

### (Third modification)

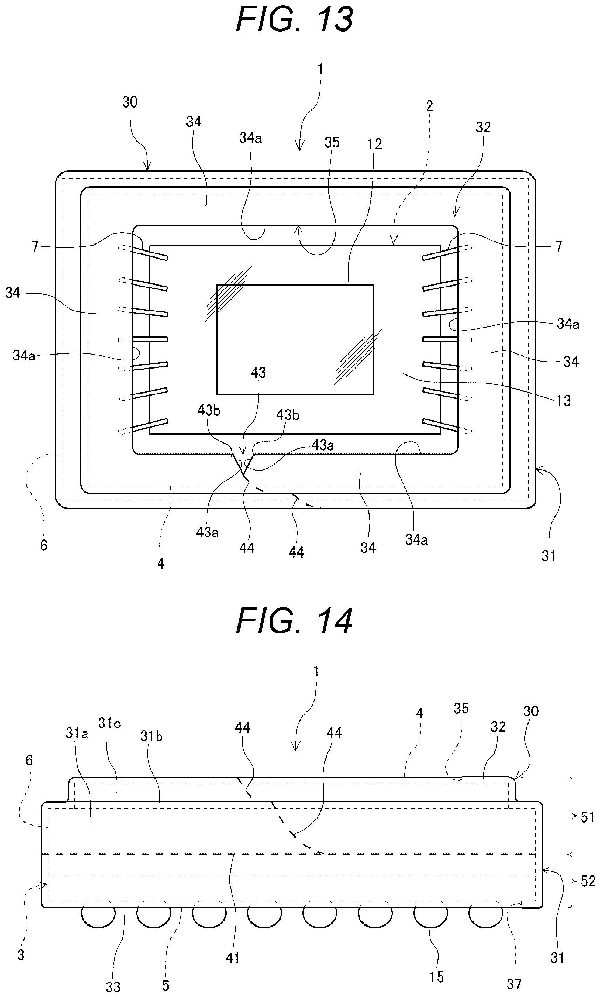

A third modification is a modification of the form of the perforation of the cover film 30 and the formation site of the cutout portion 43. As illustrated in Figs. 13 to 15, the third modification has one curved perforation 44 instead of the pair of longitudinal perforations 42 as the perforation formed in the upper film portion 51.

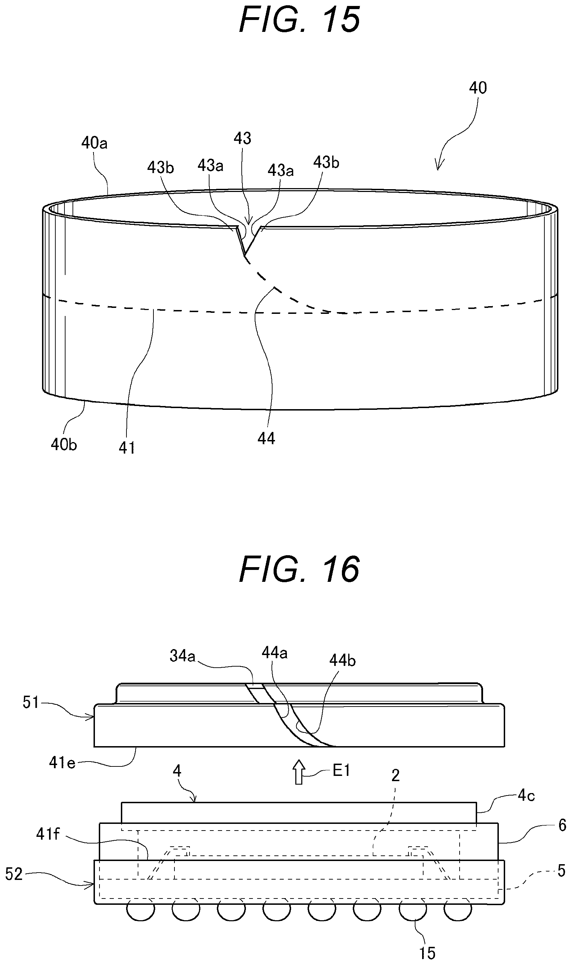

In the heat-shrinkable tube 40, the curved perforation 44 has a curved shape in which a position in the circumferential direction of the heat-shrinkable tube 40 gradually changes to one direction side (right direction side in Fig. 15) from the upper edge end portion of the heat-shrinkable tube 40 toward the lateral perforation 41 in the side view of the heat-shrinkable tube 40. The curved perforation 44 is formed in the heat-shrinkable tube 40 so as to form a curved line obliquely crossing a portion above the lateral perforation 41 to be the upper film portion 51 of the cover film 30 in a curved shape. The curved shape of the curved perforation 44 in the heat-shrinkable tube 40 is a curved shape in which the lateral perforation 41 side is a convex side.

The curved perforation 44 is formed over the entire longitudinal direction with respect to the upper film portion 51. That is, the curved perforation 44 is formed in a range from the edge portion on the opening side of the upper surface covering portion 32 forming the upper surface opening portion 35 to the lateral perforation 41. The annular upper film portion 51 is divided at one location in the circumferential direction by the curved perforation 44.

The cutout portion 43 is formed at a position corresponding to the formation site of the curved perforation 44 so as to be continuous with the curved perforation 44. That is, the cutout portion 43 is formed such that an intersection portion of the pair of oblique side portions 43a is continuous with an end portion on one side of the curved perforation 44. In this manner, the cutout portion 43 is formed so as to be connected to the end portion of the curved perforation 44 on the side opposite to the lateral perforation 41.

The cutout portion 43 forms a pair of corner portions 34b at the edge portion of the upper surface covering portion 32 on the upper surface opening portion 35 side (see Fig. 13). The corner portion 34b is an obtuse corner portion formed by the pair of oblique side portions 43a forming the cutout portion 43 and an edge end 34a of the side portion 34.

The cutout portion 43 serves as a guide when the cover film 30 is broken by the curved perforation 44, and breaking is performed by the curved perforation 44 with the cutout portion 43 as a trigger portion. Furthermore, the corner portion 34b is used as a knob portion when the cover film 30 is broken by the curved perforation 44.

A method for removing the cover glass 4 in the configuration of the third modification will be described with reference to Fig. 16. In the stripping of the upper film portion 51 performed when the cover glass 4 is removed, at least one of the pair of corner portions 34b is used as a knob portion, and the upper film portion 51 is separated from the lower film portion 52 by using the curved perforation 44 and the lateral perforation 41 as break lines.

By stripping off the upper film portion 51, the side portions 44a and 44b after breakage by the curved perforation 44 and a side portion 41e after breakage by the lateral perforation 41 are generated in the upper film portion 51. Furthermore, in the lower film portion 52, a side portion 41f after breakage by the lateral perforation 41 is generated.

After the upper film portion 51 is stripped off, the cover glass 4 is removed from the frame 6 similarly to the case described above, and the solid-state imaging device 1A having the lower film portion 52 as the covering portion is obtained (see Fig. 9C).

According to the configuration of the third modification, the upper film portion 51 separated by the perforation is an integrated film portion, so that the upper film portion 51 can be stripped off by a relatively simple operation. Therefore, excellent removability can be obtained for the upper film portion 51, and excellent workability can be obtained for peeling work of the cover film 30 when the cover glass 4 is removed.

### (Fourth modification)

A fourth modification is a modification of the form of the perforation of the cover film 30. Each of the cover films 30 described above has a configuration of a film upper portion removal type in which a portion of the upper film portion 51 is stripped when the cover glass 4 is removed. On the other hand, the cover film 30 of the fourth modification has a configuration of an entire film removal type in which the entire cover film 30 is stripped when the cover glass 4 is removed.

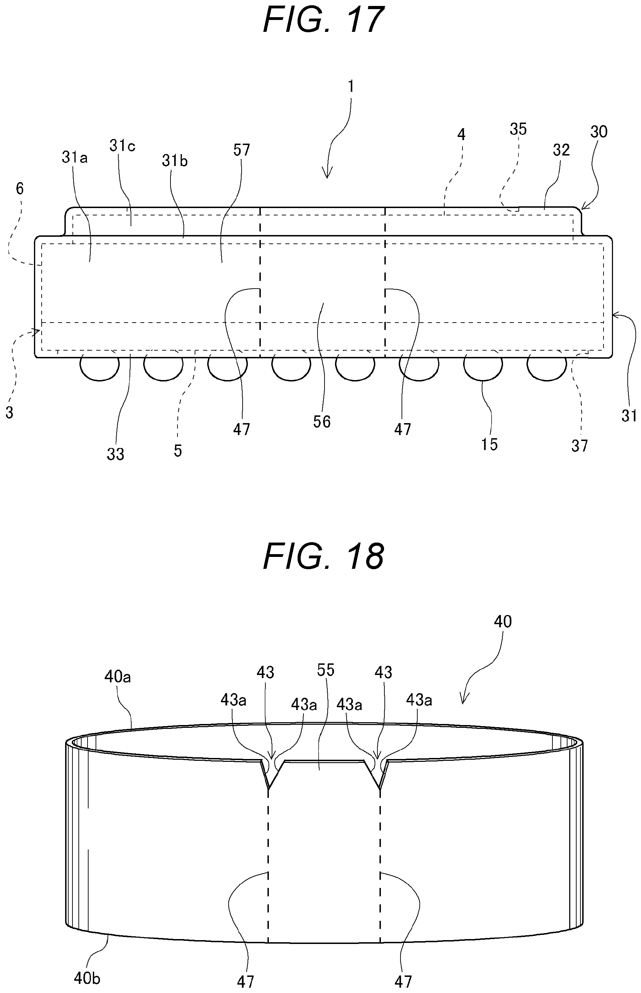

As illustrated in Figs. 17 and 18, in the fourth modification, not the lateral perforation 41 (see Fig. 3), but a pair of longitudinal perforations 47 is provided as the perforation formed in the cover film 30.

The longitudinal perforation 47 is a perforation in a mode in which the longitudinal perforation 42 described above is extended downward. The longitudinal perforation 47 is formed to have a linear shape in the longitudinal direction (up-down direction) in the side view of the solid-state imaging device 1. The pair of longitudinal perforations 47 is formed so as to be positioned in the vicinity of each other in the circumferential direction in the cover film 30.

The longitudinal perforation 47 is formed over the entire longitudinal direction with respect to the cover film 30. That is, the longitudinal perforation 47 is formed in a range from the edge portion on the opening side of the upper surface covering portion 32 forming the upper surface opening portion 35 to the edge portion (edge end 36a) on the opening side of the lower surface covering portion 33 forming the lower surface opening portion 37.

The cover film 30 is partitioned by the pair of longitudinal perforations 47 into an extraction portion 56 between the pair of longitudinal perforations 47 and a band portion 57 which is a portion other than the extraction portion 56 and forms the most part of the cover film 30. That is, the cover film 30 is divided into two parts, the extraction portion 56 and the band portion 57 by being separated along the pair of longitudinal perforations 47.

The cutout portion 43 is formed with respect to each longitudinal perforation 42 at the opening edge portion of the upper surface opening portion 35 in a relationship similar to the positional relationship with respect to the longitudinal perforation 47. The pair of cutout portions 43 forms the projecting piece portion 55 at the edge portion of upper surface covering portion 32 on the upper surface opening portion 35 side.

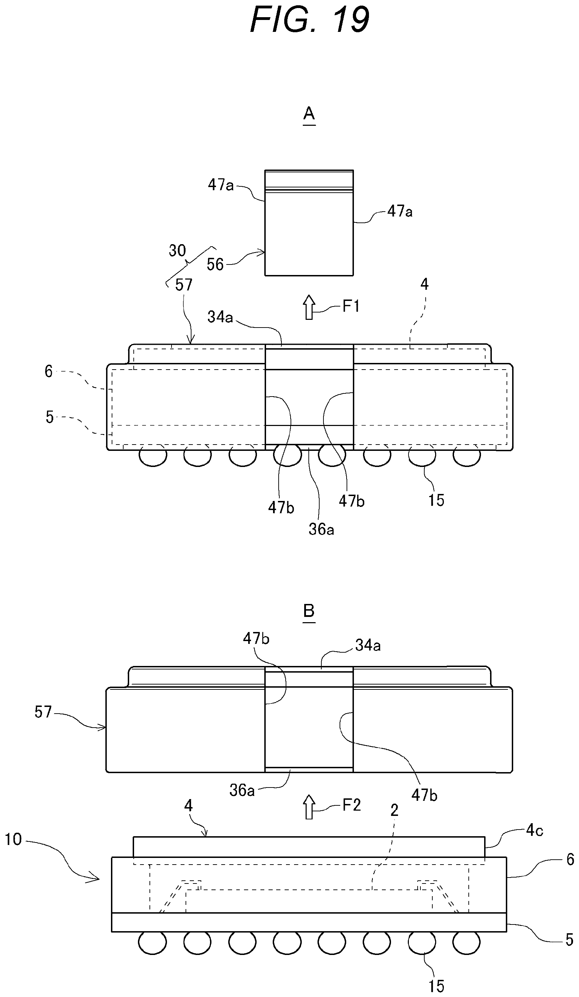

A method for removing the cover glass 4 in the configuration of the fourth modification will be described with reference to Fig. 19. First, as illustrated in Fig. 19A, the extraction portion 56 of the cover film 30 is stripped off (see arrow F1). In the stripping of the extraction portion 56, the projecting piece portion 55 is used as a knob portion, and the extraction portion 56 is separated from the band portion 57 by using the left and right longitudinal perforations 47 as break lines. By stripping off the extraction portion 56, the side portions 47a and 47b after being broken by the longitudinal perforations 47 are generated in the extraction portion 56 and the band portion 57, respectively.

Next, as illustrated in Fig. 19B, the remaining band portion 57 is stripped off (see arrow F2). Therefore, the entire device main body portion 10 is exposed, and the cover glass 4 is removed from the frame 6 similarly to the case described above (see Fig. 9C). By removing the cover glass 4 from the device main body portion 10, the sensor installation package substrate 50 (see Fig. 7A) is obtained.

As in the fourth modification, the perforation of the cover film 30 may be for peeling the entire cover film 30 from the device main body portion 10. That is, the perforation of the cover film 30 is only required to be a perforation for peeling at least a part of the cover film 30 from the device main body portion 10.

According to the configuration of the fourth modification, the entire cover film 30 can be stripped by a relatively simple operation without leaving the cover film 30 on the device main body portion 10 side. Therefore, excellent workability can be obtained for the peeling work of the cover film 30 when the cover glass 4 is removed. The configuration of the fourth modification is adopted in a case where a part of the cover film 30 such as the lower film portion 52 as a covering portion is unnecessary on the device side in a state where the cover glass 4 is removed.

### <5. Configuration example of solid-state imaging device according to second embodiment>

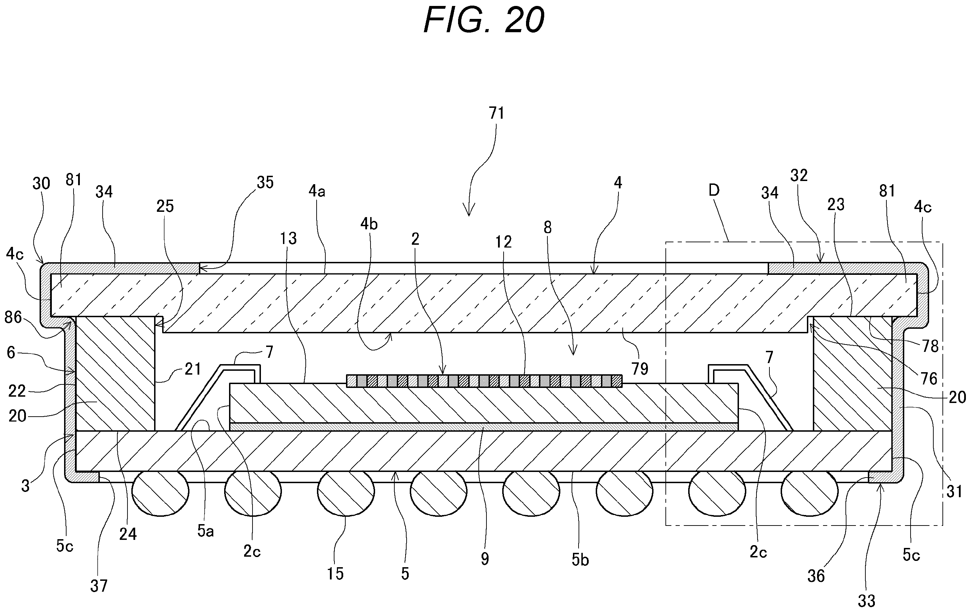

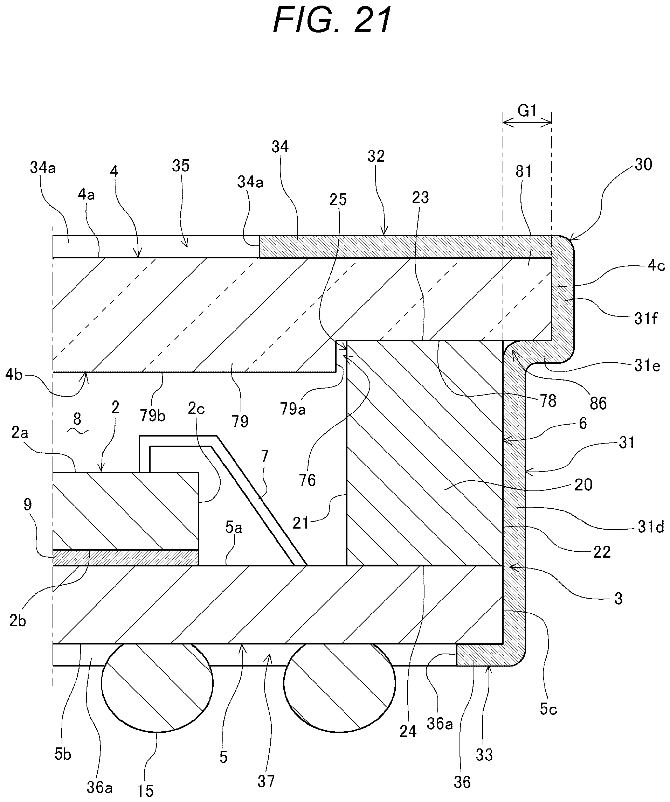

A configuration example of a solid-state imaging device 71 according to a second embodiment of the present technology will be described with reference to Figs. 20 and 21. In each embodiment to be described below, the same names or the same reference numerals are used for components common to or corresponding to components of the first embodiment, and the description of the components will be omitted as appropriate.

The solid-state imaging device 71 according to the present embodiment is different from the solid-state imaging device 1 according to the first embodiment in a fitting form between the cover glass 4 and the frame 6.

As illustrated in Figs. 20 and 21, in the present embodiment, the cover glass 4 is formed with a stepped portion 76 for fitting to a site where the opening portion 25 is formed in the frame 6. The stepped portion 76 is formed on the peripheral edge portion of the cover glass 4 along the outline of the cover glass 4 in plan view, and forms a stepped surface 78 on the lower surface 4b side of the cover glass 4.

The stepped portion 76 is a portion forming a step on the upper side with respect to the other portion of the lower surface 4b of the cover glass 4, that is, the inner portion surrounded by the stepped portion 76, and the thickness of the peripheral edge portion of the cover glass 4 is made thinner than the thickness of the other portion. The stepped portion 76 forms a horizontal stepped surface 78 at a position higher than the lower surface 4b of the other portion in the peripheral edge portion on the lower surface side of the cover glass 4.

The stepped portion 76 is formed in a rectangular frame-shaped region along the outline of the cover glass 4 in plan view so as to have a predetermined width with respect to the stepped surface 78. On the inner peripheral side of the stepped portion 76, a protruding surface portion 79 relative to the stepped surface 78 on the lower surface portion of the cover glass 4 is formed. The protruding surface portion 79 has vertical side surfaces 79a formed in the four sides and a horizontal lower surface 79b.

As described above, the cover glass 4 has, as the lower surface 4b, the stepped surface 78 of the stepped portion 76 and the lower surface 79b of the protruding surface portion 79, and is a protruding glass having a protruding shape in side cross-sectional view. The stepped portion 76 is formed by using, as processing on a glass plate, cutting with a predetermined tool such as a dicing blade or a method using etching, for example.

On the other hand, the frame 6 according to the present embodiment has a glass support surface 23 as an upper surface thereof. The glass support surface 23 is a surface formed by the upper surface of each wall portion 20, and has a rectangular frame shape in plan view. The glass support surface 23 is formed as a plane located on a predetermined virtual plane perpendicular to the up-down direction. In the frame 6, the glass support surface 23 serves as a support surface that supports the cover glass 4.

The frame 6 has a rectangular opening portion 25 on the upper side. The opening portion 25 is formed by the inner wall surfaces 21 provided on the four sides corresponding to the outline of the frame 6 in plan view. In the frame 6, the glass support surface 23 forms an opening end surface of the opening portion 25.

In the frame 6, the opening dimension of the opening portion 25 by the wall portions 20 provided on the four sides is slightly larger than the outline of the protruding surface portion 79 of the cover glass 4 in plan view. The frame 6 supports the cover glass 4 in a state where the protruding surface portion 79 of the cover glass 4 is fitted into the opening portion 25. The dimension of the side surface 79a of the protruding surface portion 79 in the up-down direction, that is, the protruding dimension of the protruding surface portion 79 with respect to the stepped surface 78 is, for example, a dimension of about 1/4 to 1/2 with respect to the thickness of the cover glass 4.

The cover glass 4 is provided on the frame 6 and closes the opening portion 25 of the package main body portion 3. The cover glass 4 is supported on the frame 6 in a state where the protruding surface portion 79 is fitted in the opening portion 25 of the frame 6. In a state where the cover glass 4 is supported by the frame 6, the stepped surface 78 serves as a contact surface with respect to the glass support surface 23 of the frame 6, and the side surfaces 79a provided on the four sides of the protruding surface portion 79 each serve as a contact surface or a facing surface with respect to the upper end portion of the inner wall surface 21 of the wall portion 20.

The cover glass 4 is fitted to the protruding surface portion 79 so as to be easily removed from the frame 6. For example, the cover glass 4 may be provided in a state of being fitted to the frame 6 with play. Thus, for example, as illustrated in Fig. 21, there may be a gap between the side surface 79a of the cover glass 4 and the inner wall surface 21 of the frame 6.

Furthermore, the cover glass 4 has an outline dimension larger than the outline of the frame 6 in plan view, and has an overhanging portion (hereinafter, referred to as a "glass overhanging portion") 81 overhanging outward from the outline of the frame 6 in plan view.

The dimension of the cover glass 4 in each of the first direction and the second direction, which are directions along the outline of the rectangular plate shape in plan view and orthogonal to each other, is made longer than the dimension of the frame 6 in the corresponding direction. Then, in the cover glass 4, the edge portions provided on the four sides in plan view protrude from the frame 6 in an eaves shape, and the protruding portion is the glass overhanging portion 81.

In the cover glass 4, the four edge portions provided on the four sides in the constant width are set as the glass overhanging portion 81 with respect to the frame 6. That is, the glass overhanging portion 81 is a portion of the cover glass 4 that protrudes outward from the outer wall surfaces 22 of the four wall portions 20 of the frame 6, and is a portion having a predetermined width dimension G1 from each side surface 4c (see Fig. 21). The width dimension G1 is a dimension between the outer wall surface 22 of the wall portion 20 and the side surface 4c of the cover glass 4. The width dimension G1 of the glass overhanging portion 81 is not particularly limited, but the width dimension G1 is, for example, a dimension shorter than the wall thickness of the wall portion 20.

As described above, in a configuration in which the cover glass 4 has the glass overhanging portion 81 at the edge portions provided on the four sides in the outline in plan view, the portion outside the stepped surface 78, that is, the lower surface portion of the glass overhanging portion 81 in the lower surface 4b of the cover glass 4 is a portion exposed to the frame 6. Furthermore, the entire side surface 4c of the cover glass 4 is exposed from the frame 6. Then, the glass overhanging portion 81 forms a stepped portion 86 between each wall portion 20 of the frame 6 and the cover glass 4 (see Fig. 21).

In the cover film 30 according to the present embodiment, the covering main body portion 31 which is a portion covering the package main body portion 3 and the cover glass 4 from the side has the following portions. That is, the covering main body portion 31 has, in order from the lower side to the upper side, a lower vertical surface portion 31d which is a covering surface portion having a vertical shape, a horizontal surface portion 31e which is a covering surface portion having a horizontal shape, and an upper vertical surface portion 31f which is a covering surface portion having a vertical shape (see Fig. 21).

As illustrated in Fig. 21, the lower vertical surface portion 31d is a portion covering the side surface 5c of the substrate 5 and the outer wall surface 22 of the wall portion 20 of the frame 6 which form a flush surface. The horizontal surface portion 31e is a portion connected to the upper end of the lower vertical surface portion 31d, and is a portion covering a portion of the lower surface of the glass overhanging portion 81 in the stepped surface 78 of the cover glass 4. The upper vertical surface portion 31f is a portion connected to an outer edge end of the horizontal surface portion 31e, and is a portion covering the side surface 4c of the cover glass 4.

Each of the combination of the lower vertical surface portion 31d and the horizontal surface portion 31e and the combination of the horizontal surface portion 31e and the upper vertical surface portion 31f forms a right-angled corner portion in side cross-sectional view by following the shape of the object to be covered (see Fig. 21). The stepped portion 86 formed by the frame 6 and the cover glass 4 in the upper portion of the package is covered with the upper portion of the lower vertical surface portion 31d and the horizontal surface portion 31e.

### <6. Method for manufacturing solid-state imaging device according to second embodiment>

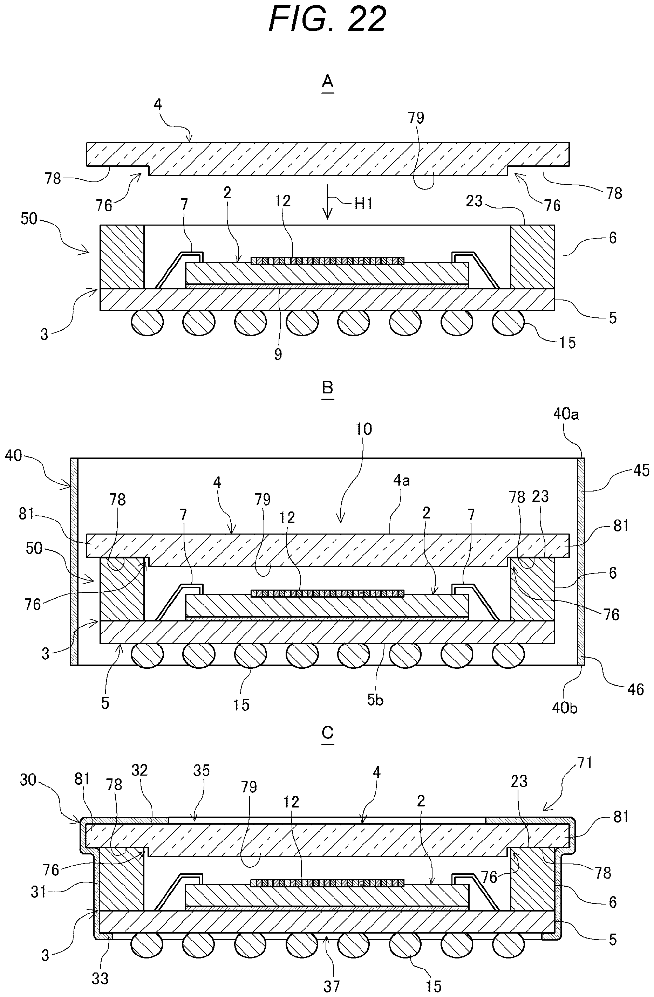

An example of a method for manufacturing the solid-state imaging device 71 according to the second embodiment of the present technology will be described with reference to Fig. 22. The solid-state imaging device 71 is manufactured by a method similar to the method for manufacturing the solid-state imaging device 1 of the first embodiment.

As illustrated in Fig. 22A, a step of installing the cover glass 4 on the sensor installation package substrate 50 manufactured by a predetermined step is performed. The cover glass 4 is installed on the frame 6 so as to fitted to the protruding surface portion 79 (see an arrow H1). Therefore, the device main body portion 10 having a configuration in which the cover glass 4 is set on the sensor installation package substrate 50 is obtained (see Fig. 22B).

Next, as illustrated in Fig. 22B, a step of setting the heat-shrinkable tube 40 with respect to the device main body portion 10 so as to surround the device main body portion 10 with the heat-shrinkable tube 40 is performed.

Then, as illustrated in Fig. 22C, a step of forming the cover film 30 by heat-shrinking the heat-shrinkable tube 40 is performed. This step is a step of heating and shrinking the heat-shrinkable tube 40 to cover the device main body portion 10 with the heat-shrinkable tube 40 and fix the cover glass 4 to the frame 6.

Through the manufacturing step as described above, the solid-state imaging device 71 is obtained. Note that the step of heating and shrinking the heat-shrinkable tube 40 may also serve as the step of reflow-installing the solid-state imaging device 71 on the set substrate.

In the solid-state imaging device 71 according to the present embodiment, the stepped portion 76 for fitting to the frame 6 is formed on the lower surface 4b side of the cover glass 4. According to such a configuration, the cover glass 4 can be positioned with respect to the frame 6, so that the positional displacement of the cover glass 4 held by the frame 6 can be prevented by the cover film 30 without using an adhesive. Furthermore, according to the configuration in which the stepped portion 76 is provided on the cover glass 4, the upper surface of the frame 6 can be the flat glass support surface 23, and thus, for example, an existing frame member can be used as a member forming the frame 6.

Furthermore, the cover glass 4 has the glass overhanging portion 81 in relation to the frame 6. According to such a configuration, the area of the portion covered with the cover film 30 with respect to the cover glass 4 can be enlarged. Therefore, the fixing action of the cover glass 4 with respect to the frame 6 by the cover film 30 can be improved, so that the positional displacement of the cover glass 4 can be effectively prevented, and a stable fixed state of the cover glass 4 can be obtained.

### <7. Modification of solid-state imaging device according to second embodiment>

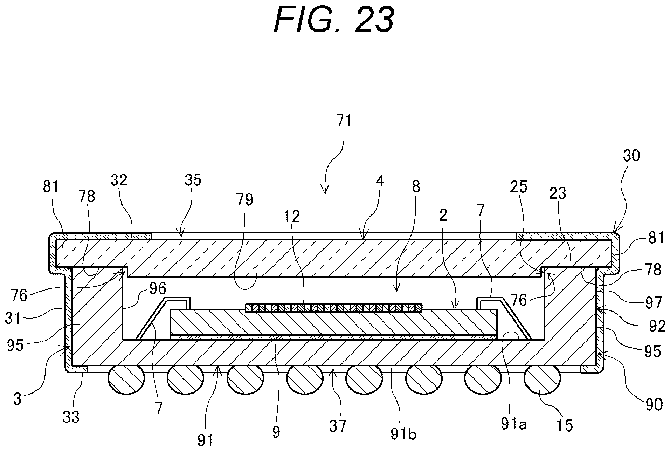

A modification of the solid-state imaging device 71 according to the second embodiment will be described with reference to Fig. 23. As illustrated in Fig. 23, in the configuration of this modification, the package main body portion 3 includes an integrated cavity substrate 90 having a cavity portion. That is, each portion of the cavity substrate 90 forms a portion corresponding to each of the substrate 5 and the frame 6.

The cavity substrate 90 is a package substrate forming a box-shaped package main body portion 3 with an upper side as an open side. The cavity substrate 90 includes a substrate portion 91 on which the image sensor 2 is installed, and a frame portion 92 that is provided on the upper side of the substrate portion 91 so as to surround the image sensor 2 and has the opening portion 25 formed on the upper side. The cavity substrate 90 forms the cavity 8 together with the cover glass 4 by being fitted by the stepped portion 76 of the cover glass 4 at the opening portion 25.

The substrate portion 91 is a rectangular plate-like flat plate portion and is a portion corresponding to the substrate 5 having the configuration illustrated in Fig. 20. The substrate portion 91 has a front surface 91a on which the image sensor 2 is installed and a back surface 91b on the opposite side from the front surface 91a. The image sensor 2 is bonded onto the front surface 91a by a die bonding material 9. The substrate portion 91 and the image sensor 2 are electrically connected by a plurality of wires 7 each having one end connected to an electrode formed on the front surface 91a. A plurality of terminal electrodes is formed on the back surface 91b side, and each terminal electrode is provided with the solder ball 15.

The frame portion 92 is a frame-shaped portion and is a portion corresponding to the frame 6 having the configuration illustrated in Fig. 20. The upper surface of the frame portion 92 is the glass support surface 23. The frame portion 92 includes wall portions 95 provided on the four sides that form the glass support surface 23 in a rectangular frame shape in plan view. The wall portion 95 is a portion similar in outline to the wall portion 20 of the frame 6, and has an inner wall surface 96 and an outer wall surface 97. Furthermore, the frame portion 92 has the rectangular opening portion 25 on the upper side.

The cavity substrate 90 is a circuit board on which a predetermined circuit is formed, and is a multilayered ceramic substrate including layers of ceramic sheet members or the like. Note that the cavity substrate 90 may be another type of substrate such as an organic substrate.

As in this modification, the package main body portion according to the present technology may include an integrated member like the cavity substrate 90. Adopting such a configuration eliminates the need of the frame 6 and can simplify the package structure and the package manufacturing process. Note that, also in the cavity substrate 90, similarly to the stepped portion 26 of the frame 6 according to the first embodiment, a configuration may be adopted in which the flat plate-shaped cover glass 4 (not including the stepped portion 76) is positioned by providing the stepped portion in the frame portion 92.

### <8. Configuration example of solid-state imaging device according to third embodiment>

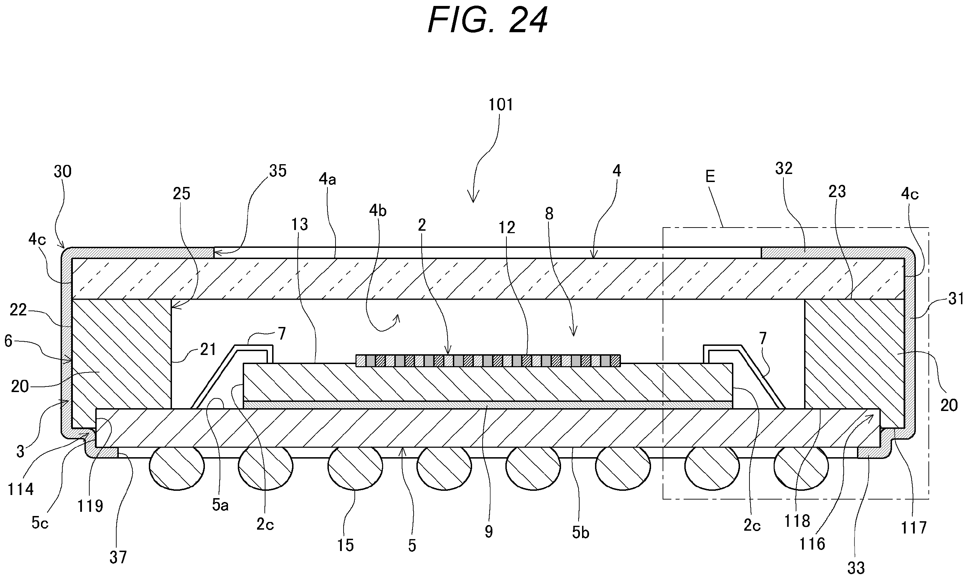

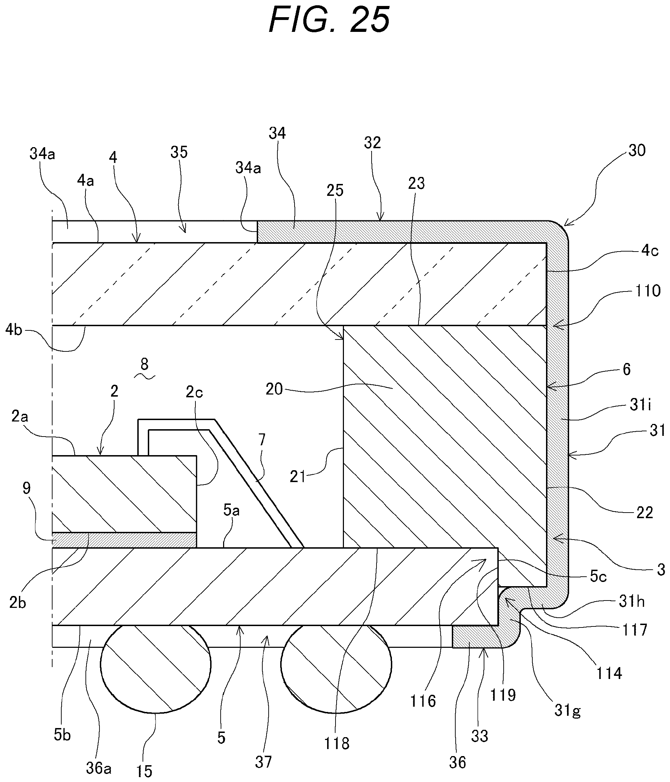

A configuration example of a solid-state imaging device 101 according to a third embodiment of the present technology will be described with reference to Figs. 24 and 25.

The solid-state imaging device 101 according to the present embodiment is different from the solid-state imaging device 1 according to the first embodiment in terms of an attachment structure between members in a package structure.

As illustrated in Figs. 24 and 25, the frame 6 is provided as a separate portion from the substrate 5, and a stepped portion 116 for fitting the substrate 5 is formed in the frame 6. The stepped portion 116 is formed along the outline of the frame 6 in bottom view, and forms a stepped surface 118 toward a higher side with respect to a lower surface 117 having a rectangular frame shape in bottom view and formed by upper end surfaces of the wall portions 20 provided on the four sides in the frame 6.

That is, the frame 6 includes, as the lower surface formed by the lower surfaces of the wall portions 20 provided on the four sides, the lower surface 117 forming a portion on the outer peripheral side in the rectangular frame-shaped outline in bottom view, and the stepped surface 118 forming a portion on the inner peripheral side in the same outline in bottom view and being one step higher than the lower surface 117. The stepped portion 116 includes an inner side surface 119 as a surface formed between the lower surface 117 and the stepped surface 118. The inner side surface 119 is formed as a vertical surface positioned outside the inner wall surface 21 and parallel to the inner wall surface 21 in each wall portion 20.

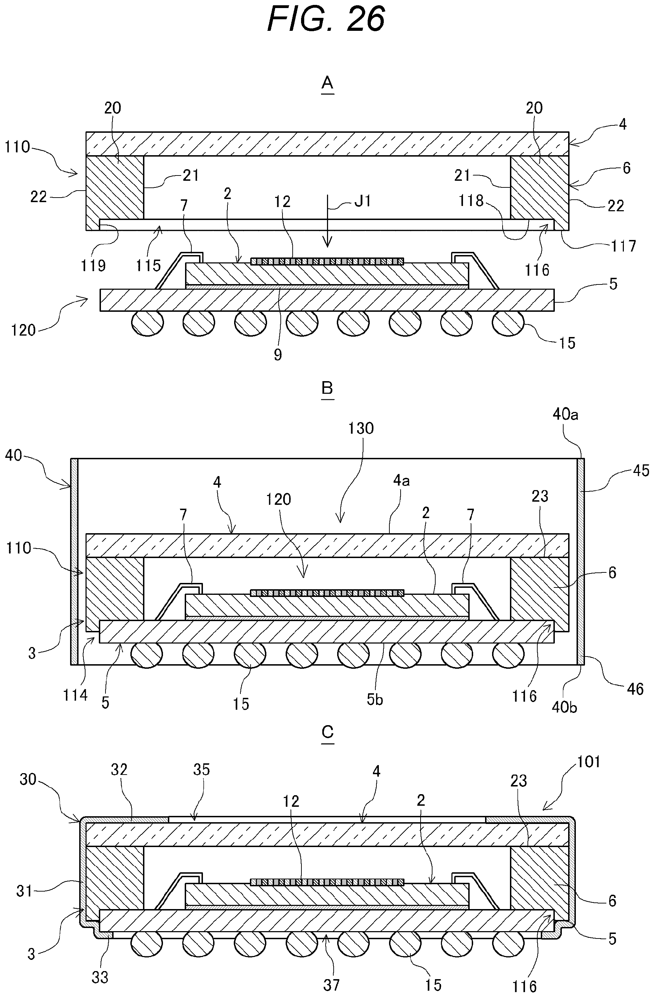

The lower surface 117 and the stepped surface 118 are each formed as a plane located on a predetermined virtual plane perpendicular to the up-down direction. In the frame 6, the stepped surface 118 serves as a substrate supporting surface supported by the substrate 5, and serves as an opening end surface of the opening portion 115 (see Fig. 26A) on the lower side of the frame 6. Note that the dimensional ratio of the lower surface 117 and the stepped surface 118 in the wall thickness direction of the wall portion 20 is not particularly limited.

In the frame 6, the stepped portion 116 has an outline in bottom view formed by the inner side surfaces 119 provided on the four sides, the outline being slightly larger than the outline of the substrate 5 in plan view. The frame 6 is supported by the substrate 5 in a state where the substrate 5 is fitted to the stepped portion 116. The dimension of the inner side surface 119 in the up-down direction is, for example, about 1/4 to 1/2 of the thickness of the substrate 5.

In the present embodiment, the frame 6 is provided as an integral part with the cover glass 4, and is provided in a state of being placed and supported on the substrate 5 without being fixed to the substrate 5 with an adhesive or the like (in a non-fixed state). That is, the frame 6 forms, as an attachment body to the substrate 5, an integral glass-attached frame 110 together with the cover glass 4 (see Fig. 26A). In the glass-attached frame 110, the lower side of the frame 6 is a rectangular opening portion 115. The opening portion 115 is formed by the inner wall surfaces 21 provided on the four sides corresponding to the outline of the frame 6 in plan view.

The frame 6 is provided on the cover glass 4 by, for example, resin molding such as injection molding. Furthermore, the frame 6 may be provided, for example, by fixing a frame-shaped frame member formed by using a resin material such as an epoxy resin to the cover glass 4 with an adhesive. The frame 6 is provided with respect to the cover glass 4 so as to make the outer wall surface 22 of each wall portion 20 flush with the side surface 4c.

The substrate 5 closes the opening portion 115 of the glass-attached frame 110. The substrate 5 supports the frame 6 in a state of being fitted to the stepped portion 116 of the frame 6. In a state in which the substrate 5 is fitted to the stepped portion 116, the front surface 5a serves as a contact surface with respect to the stepped surface 118, and the side surfaces 5c provided on the four sides serve as contact surfaces or facing surfaces with respect to the inner side surface 119.

The substrate 5 is fitted to the stepped portion 116 such that the glass-attached frame 110 can be easily removed from the substrate 5. For example, the substrate 5 may be provided in a state of being fitted to the stepped portion 116 with play. Thus, there may be a gap between the side surface 5c of the substrate 5 and the inner side surface 119 of the frame 6.

Furthermore, in a state where the frame 6 is supported by the substrate 5, a part of the substrate 5 on the lower side in the thickness direction protrudes downward from the lower surface 117 of the frame 6. That is, the substrate 5 has the upper portion of the side surface 5c in contact with or facing the inner side surface 119, and the lower portion of the side surface 5c is exposed downward from the frame 6. The lower surface 117 of the frame 6 and the side surface 5c of the substrate 5 form a stepped portion 114 formed by the frame 6 and the substrate 5 outside the lower portion of the package.

The solid-state imaging device 101 according to the present embodiment includes the cover film 30 as a configuration for fixing the glass-attached frame 110 to the substrate 5. The cover film 30 covers the package main body portion 3 and the cover glass 4 so as to surround the package main body portion 3 and the cover glass 4 from the side, thereby fixing the frame 6 to the substrate 5. That is, the solid-state imaging device 101 holds and fixes the cover glass 4 to the substrate 5 via the frame 6 by fixing the frame 6 of the glass-attached frame 110 to the substrate 5 by the cover film 30.

In the cover film 30 according to the present embodiment, the covering main body portion 31 which is a portion covering the package main body portion 3 and the cover glass 4 from the side has the following portions. That is, the covering main body portion 31 has, in order from the lower side to the upper side, a lower vertical surface portion 31g which is a covering surface portion having a vertical shape, a horizontal surface portion 31h which is a covering surface portion having a horizontal shape, and an upper vertical surface portion 31i which is a covering surface portion having a vertical shape (see Fig. 25).

As illustrated in Fig. 25, the lower vertical surface portion 31g is a portion covering a portion of the side surface 5c of the substrate 5 exposed from the frame 6, that is, a portion of the side surface 5c below the lower surface 117. The horizontal surface portion 31h is a portion connected to the upper end of the lower vertical surface portion 31g, and is a portion covering the lower surface 117 of the frame 6. The upper vertical surface portion 31i is a portion connected to an outer edge end of the horizontal surface portion 31h, and is a portion covering the outer wall surface 22 of the wall portion 20 of the frame 6 and the side surface 4c of the cover glass 4 forming a flush surface.

Each of the combination of the lower vertical surface portion 31g and the horizontal surface portion 31h and the combination of the horizontal surface portion 31h and the upper vertical surface portion 31i forms a right-angled corner portion in side cross-sectional view by following the shape of the object to be covered (see Fig. 25). The stepped portion 114 formed by the substrate 5 and the frame 6 in the lower portion of the package is covered with the lower vertical surface portion 31g and the horizontal surface portion 31h.

### <9. Method for manufacturing solid-state imaging device according to third embodiment>

An example of a method for manufacturing the solid-state imaging device 101 according to the third embodiment of the present technology will be described with reference to Fig. 26. The solid-state imaging device 101 is manufactured by a method similar to the method for manufacturing the solid-state imaging device 1 of the first embodiment.

As illustrated in Fig. 26A, a step of manufacturing, as a configuration on which the glass-attached frame 110 is mounted, a sensor installation substrate 120 which is a configuration including the substrate 5 on which the image sensor 2 is installed is performed. The sensor installation substrate 120 is manufactured by a step of fixing the image sensor 2 on the substrate 5 by the die bonding material 9, a step of electrically connecting the substrate 5 and the image sensor 2 by the plurality of wires 7, and a step of providing the plurality of solder balls 15 on the back surface 5b side of the substrate 5.

As illustrated in Fig. 26A, a step of installing the glass-attached frame 110 on the sensor installation substrate 120 is performed. The glass-attached frame 110 is installed on the substrate 5 so that the substrate 5 is fitted to the stepped portion 116 (see arrow J1). Therefore, the device main body portion 130 having a configuration in which the glass-attached frame 110 is set on the substrate 5 of the sensor installation substrate 120 is obtained (see Fig. 26B).

Next, as illustrated in Fig. 26B, a step of setting the heat-shrinkable tube 40 with respect to the device main body portion 130 so as to surround the device main body portion 130 with the heat-shrinkable tube 40 is performed.

Then, as illustrated in Fig. 26C, a step of forming the cover film 30 by heat-shrinking the heat-shrinkable tube 40 is performed. This step is a step of heating and shrinking the heat-shrinkable tube 40 to cover the device main body portion 130 with the heat-shrinkable tube 40 and fix the frame 6 (the glass-attached frame 110) to the substrate 5.

Through the manufacturing step as described above, the solid-state imaging device 101 is obtained. Note that the step of heating and shrinking the heat-shrinkable tube 40 may also serve as the step of reflow-installing the solid-state imaging device 101 on the set substrate.

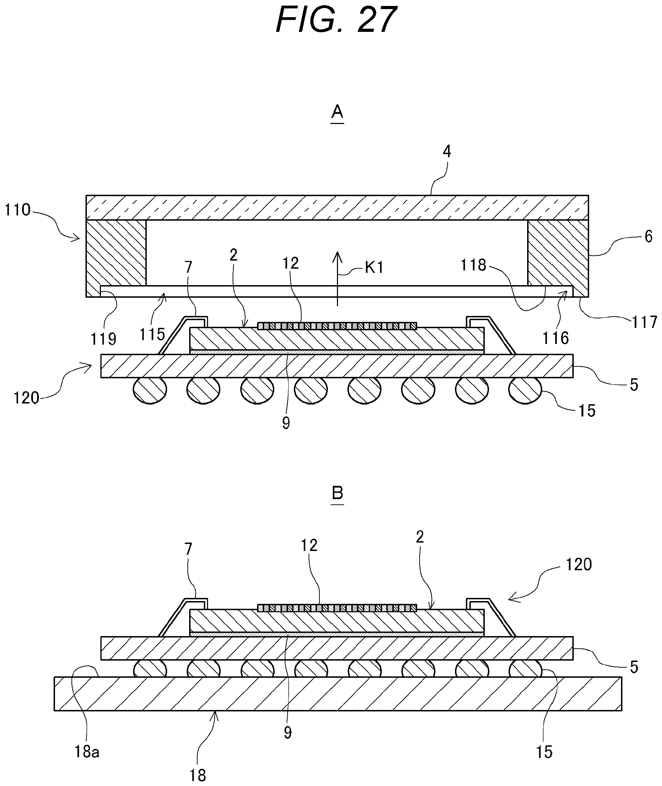

According to the solid-state imaging device 101 according to the present embodiment, by stripping off the entire cover film 30, as illustrated in Fig. 27A, the glass-attached frame 110 can be lifted with respect to the substrate 5 (see arrow K1). By removing the glass-attached frame 110 including the cover glass 4 from the substrate 5, the sensor installation substrate 120 in which the glass-attached frame 110 is removed from the device main body portion 130 is obtained.

Furthermore, the step of forming the cover film 30 by heating and shrinking the heat-shrinkable tube 40 may also serve as the step of reflow-installing the solid-state imaging device 101 on the set substrate 18, or may be performed after reflow-installing the glass-attached frame 110. In this case, by stripping off the cover film 30 and removing the glass-attached frame 110 from the substrate 5, as illustrated in Fig. 27B, a configuration in which the sensor installation substrate 120 is installed on the set substrate 18 is obtained.

In the solid-state imaging device 101 according to the present embodiment as described above, the stepped portion 116 for fitting to the substrate 5 is formed on the lower side of the frame 6 forming the glass-attached frame 110. According to such a configuration, the glass-attached frame 110 can be positioned with respect to the substrate 5, so that the positional displacement of the glass-attached frame 110 held by the substrate 5 can be prevented by the cover film 30 without using an adhesive.

### <10. Configuration example of electronic device>

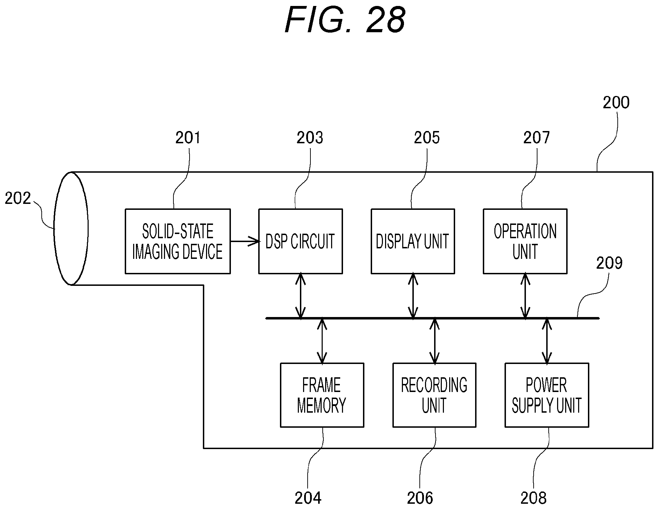

An application example of the semiconductor device according to the above-described embodiments to an electronic device will be described with reference to Fig. 28.

The semiconductor device (solid-state imaging device) according to the present technology can be used as various types of devices that sense light such as visible light, infrared light, ultraviolet light, and X-rays, for example. The solid-state imaging device according to the present technology is applicable to all electronic devices using a solid-state imaging element as an image capturing unit (photoelectric converter), such as a camera device such as a digital still camera or a video camera, a mobile terminal device having an imaging function, a copying machine using a solid-state imaging element as an image reading unit, an in-vehicle sensor that captures images of the front, rear, surroundings, inside, and the like of an automobile, and a ranging sensor that measures a distance between vehicles and the like. Furthermore, the solid-state imaging device may be formed as one chip, or may be in the form of a module having an imaging function in which an imaging unit and a signal processing unit or an optical system are packaged together.

As illustrated in Fig. 28, a camera device 200 as an electronic device includes an optical unit 202, a solid-state imaging device 201, a digital signal processor (DSP) circuit 203 which is a camera signal processing circuit, a frame memory 204, a display unit 205, a recording unit 206, an operation unit 207, and a power supply unit 208. The DSP circuit 203, the frame memory 204, the display unit 205, the recording unit 206, the operation unit 207, and the power supply unit 208 are appropriately connected via a connection line 209 such as a bus line. The solid-state imaging device 201 is any one of the solid-state imaging devices according to the above-described embodiments. Furthermore, for example, the solid-state imaging device 201 may be the solid-state imaging device 1A (see Fig. 9C) or a solid-state imaging device having a configuration in which the cover glass 4 is removed from the device main body portion 10 (see Fig. 9B) or being in a state where the cover glass 4 is removed from the sensor installation substrate 120 or the like (see Fig. 27A).

The optical unit 202 includes a plurality of lenses, and captures incident light (image light) from a subject to form an image on an imaging surface of the solid-state imaging device 201. The solid-state imaging device 201 converts the light amount of the incident light imaged on the imaging surface by the optical unit 202 into an electrical signal for each pixel and outputs the electrical signal as a pixel signal.

The display unit 205 includes, for example, a panel type display device such as a liquid crystal panel or an organic electro luminescence (EL) panel, and displays a moving image or a still image captured by the solid-state imaging device 201. The recording unit 206 records the moving image or the still image captured by the solid-state imaging device 201 on a recording medium such as a hard disk or a semiconductor memory.

The operation unit 207 issues operation commands for various functions of the camera device 200 under operation by the user. The power supply unit 208 appropriately supplies various power sources serving as operation power sources of the DSP circuit 203, the frame memory 204, the display unit 205, the recording unit 206, and the operating unit 207 to supply targets.

According to the camera device 200 as described above, regarding the solid-state imaging device 201, in a state where the cover glass 4 is removed from the package main body portion 3, the cover glass 4 can be easily removed without leaving an adhesive for fixing the cover glass 4, and entry of dust into the cavity 8 can be suppressed without causing deformation of the package at the time of reflow.

The description of the above-described embodiments is an example of the present technology, and the present technology is not limited to the above-described embodiments. For this reason, it is a matter of course that various modifications can be made according to the design and the like without departing from the technical idea according to the present disclosure even in a case other than the above-described embodiments. Furthermore, the effects described in the present disclosure are merely examples and are not limited, and other effects may be provided. Furthermore, the configurations of the above-described embodiments and the configuration of each modification can be appropriately combined.

In the above-described embodiments, the semiconductor element is the image sensor 2 that is a light receiving element, but the semiconductor element according to the present technology is not limited to an image sensor. The semiconductor element according to the present technology may be, for example, a light emitting element such as a vertical cavity surface emitting laser (VCSEL), a laser diode, or a light emitting diode (LED). Furthermore, the imaging device as a semiconductor device may have a configuration where a plurality of semiconductor elements is provided in one chip or a configuration where a plurality of semiconductor elements is provided as a plurality of chips.

Furthermore, in the above-described embodiments, the transparent cover glass 4 has been given as an example of the cover member according to the present technology, but the cover member according to the present technology is not limited to a transparent member, and may be a translucent or opaque cover body.

Furthermore, in the above-described embodiment, the cover film 30 fixes the cover glass 4 to the frame 6 (the fixation of the glass) or fixes the frame 6 (the glass-attached frame 110) to the substrate 5 (the fixation of the frame). However, the cover film may fix both the cover glass 4 and the substrate 5. That is, the solid-state imaging device according to the present technology may have a configuration in which both the fixation of the glass and the fixation of the frame are performed by the cover film 30 in a configuration in which the members of the substrate 5, the frame 6, and the cover glass 4 are not fixed to each other by an adhesive or the like. As described above, the cover film 30 performs at least one of the fixation of the glass and the fixation of the frame.

Furthermore, in the above-described embodiment, the formation sites and the number of the perforations such as the lateral perforation 41 and the cutout portion 43 of the cover film 30 are not limited. For example, the cutout portion 43 may be formed at the opening edge portion of the lower surface opening portion 37 in the cover film 30, and a perforation may be formed so as to be continuous with the cutout portion 43 formed at the opening edge portion of the lower surface opening portion 37.

Note that the present technology can also employ the following configurations.
(1) A semiconductor device including:
   a semiconductor element;
   a package main body portion which includes a substrate portion on which the semiconductor element is installed, and a frame portion which is provided on the substrate portion so as to surround the semiconductor element and has an opening portion formed on an upper side;
   a cover member which is provided on the frame portion and closes the opening portion; and
   a covering portion which covers the package main body portion and the cover member so as to surround the package main body portion and the cover member from a side, thereby performing at least one of fixing the cover member to the frame portion or fixing a member forming the frame portion to a member forming the substrate portion.
(2) The semiconductor device according to (1), in which
   the covering portion is formed by using a film member including a thermoplastic resin material which is heat-shrinkable.
(3) The semiconductor device according to (1) or (2), in which
   the covering portion includes
   a covering main body portion which covers the package main body portion and the cover member from a side,
   an upper surface covering portion which covers a part of an upper surface side of the cover member, and
   a lower surface covering portion which covers a part of a lower surface side of the substrate portion.
(4) The semiconductor device according to any one of (1) to (3), in which
   the covering portion has at least one of a perforation for peeling at least a part of the covering portion from the package main body portion and the cover member or a cutout portion formed in an opening edge portion of the covering portion.
(5) The semiconductor device according to any one of (1) to (4), in which
   the covering portion includes
   an upper covering portion which covers an upper portion of the frame portion and the cover member, and
   a lower covering portion which is a portion lower than the upper covering portion, and
   a break line portion which facilitates separation between the upper covering portion and the lower covering portion is formed at a boundary between the upper covering portion and the lower covering portion.
(6) The semiconductor device according to any one of (1) to (5), in which
   the covering portion has a light shielding property.
(7) The semiconductor device according to any one of (1) to (6), in which
   a stepped portion for fitting the cover member is formed at a formation site of the opening portion in the frame portion.
(8) The semiconductor device according to any one of (1) to (7), in which
   the cover member is formed with a stepped portion for fitting to a formation site of the opening portion in the frame portion.
(9) The semiconductor device according to (8), in which
   the cover member has an outline dimension larger than an outline of the frame portion in plan view, and includes an overhanging portion overhanging outward from the outline of the frame portion in plan view.
(10) The semiconductor device according to any one of (1) to (9), in which
   the frame portion is provided as a separate portion from the member forming the substrate portion, and
   a stepped portion for fitting the member forming the substrate portion is formed in the member forming the frame portion.
(11) An electronic device including a semiconductor device, the semiconductor device including:
   a semiconductor element;
   a package main body portion which includes a substrate portion on which the semiconductor element is installed, and a frame portion which is provided on the substrate portion so as to surround the semiconductor element and has an opening portion formed on an upper side;
   a cover member which is provided on the frame portion and closes the opening portion; and
   a covering portion which covers the package main body portion and the cover member so as to surround the package main body portion and the cover member from a side, thereby performing at least one of fixing the cover member to the frame portion or fixing a member forming the frame portion to a member forming the substrate portion.
(12) An electronic device including a semiconductor device, the semiconductor device including:
   a semiconductor element;
   a package main body portion which includes a substrate portion on which the semiconductor element is installed, and a frame portion which is provided on the substrate portion so as to surround the semiconductor element and has an opening portion formed on an upper side; and
   a covering portion which covers the package main body portion so as to surround the package main body portion from a side.
(13) A method for manufacturing a semiconductor device, the method including:
   a step of setting a film member to a configuration including a semiconductor element, a package main body portion which includes a substrate portion on which the semiconductor element is installed, and a frame portion which is provided on the substrate portion so as to surround the semiconductor element and has an opening portion formed on an upper side, and a cover member which is provided on the frame portion so as to close the opening portion, so as to cover the configuration with a cylindrical film member including a thermoplastic resin material which is heat-shrinkable; and
   a step of heating and shrinking the film member to bring the film member into close contact with the configuration, covering the package main body portion and the cover member with the film member so as to surround the package main body portion and the cover member from a side, and performing at least one of fixing the cover member to the frame portion or fixing a member forming the frame portion to a member forming the substrate portion.

### REFERENCE SIGNS LIST

- 1: Solid-state imaging device (semiconductor device)
- 1A: Solid-state imaging device (semiconductor device)
- 2: Image sensor (semiconductor element)
- 3: Package main body portion
- 4: Cover glass (cover member)
- 5: Substrate (substrate portion)
- 6: Frame (frame portion)
- 25: Opening portion
- 26: Stepped portion
- 30: Cover film (covering portion)
- 31: Covering main body portion
- 32: Upper surface covering portion
- 33: Lower surface covering portion
- 35: Upper surface opening portion
- 40: Heat-shrinkable tube (film member)
- 41: Lateral perforation (break line portion)
- 42: Longitudinal perforation
- 43: Cutout portion
- 44: Curved perforation
- 47: Longitudinal perforation
- 51: Upper film portion (upper covering portion)
- 52: Lower film portion (lower covering portion, covering portion)
- 71: Solid-state imaging device (semiconductor device)
- 76: Stepped portion
- 81: Glass overhanging portion (overhanging portion)
- 90: Cavity substrate
- 91: Substrate portion
- 92: Frame portion
- 101: Solid-state imaging device (semiconductor device)
- 110: Glass-attached frame
- 116: Stepped portion
- 200: Camera device (electronic device)
- 201: Solid-state imaging device (semiconductor device)

## Claims

1. A semiconductor device comprising:
a semiconductor element;
a package main body portion which includes a substrate portion on which the semiconductor element is installed, and a frame portion which is provided on the substrate portion so as to surround the semiconductor element and has an opening portion formed on an upper side;
a cover member which is provided on the frame portion and closes the opening portion; and
a covering portion which covers the package main body portion and the cover member so as to surround the package main body portion and the cover member from a side, thereby performing at least one of fixing the cover member to the frame portion or fixing a member forming the frame portion to a member forming the substrate portion.

2. The semiconductor device according to claim 1, wherein
the covering portion is formed by using a film member including a thermoplastic resin material which is heat-shrinkable.

3. The semiconductor device according to claim 1, wherein
the covering portion includes
a covering main body portion which covers the package main body portion and the cover member from a side,
an upper surface covering portion which covers a part of an upper surface side of the cover member, and
a lower surface covering portion which covers a part of a lower surface side of the substrate portion.

4. The semiconductor device according to claim 1, wherein
the covering portion has at least one of a perforation for peeling at least a part of the covering portion from the package main body portion and the cover member or a cutout portion formed in an opening edge portion of the covering portion.

5. The semiconductor device according to claim 1, wherein
the covering portion includes
an upper covering portion which covers an upper portion of the frame portion and the cover member, and
a lower covering portion which is a portion lower than the upper covering portion, and
a break line portion which facilitates separation between the upper covering portion and the lower covering portion is formed at a boundary between the upper covering portion and the lower covering portion.

6. The semiconductor device according to claim 1, wherein
the covering portion has a light shielding property.

7. The semiconductor device according to claim 1, wherein
a stepped portion for fitting the cover member is formed at a formation site of the opening portion in the frame portion.

8. The semiconductor device according to claim 1, wherein
the cover member is formed with a stepped portion for fitting to a formation site of the opening portion in the frame portion.

9. The semiconductor device according to claim 8, wherein
the cover member has an outline dimension larger than an outline of the frame portion in plan view, and includes an overhanging portion overhanging outward from the outline of the frame portion in plan view.

10. The semiconductor device according to claim 1, wherein
the frame portion is provided as a separate portion from the member forming the substrate portion, and
a stepped portion for fitting the member forming the substrate portion is formed in the member forming the frame portion.

11. An electronic device comprising a semiconductor device, the semiconductor device including:
a semiconductor element;
a package main body portion which includes a substrate portion on which the semiconductor element is installed, and a frame portion which is provided on the substrate portion so as to surround the semiconductor element and has an opening portion formed on an upper side;
a cover member which is provided on the frame portion and closes the opening portion; and
a covering portion which covers the package main body portion and the cover member so as to surround the package main body portion and the cover member from a side, thereby performing at least one of fixing the cover member to the frame portion or fixing a member forming the frame portion to a member forming the substrate portion.

12. An electronic device comprising a semiconductor device, the semiconductor device including:
a semiconductor element;
a package main body portion which includes a substrate portion on which the semiconductor element is installed, and a frame portion which is provided on the substrate portion so as to surround the semiconductor element and has an opening portion formed on an upper side; and
a covering portion which covers the package main body portion so as to surround the package main body portion from a side.

13. A method for manufacturing a semiconductor device, the method comprising:
a step of setting a film member to a configuration including a semiconductor element, a package main body portion which includes a substrate portion on which the semiconductor element is installed, and a frame portion which is provided on the substrate portion so as to surround the semiconductor element and has an opening portion formed on an upper side, and a cover member which is provided on the frame portion so as to close the opening portion, so as to cover the configuration with a cylindrical film member including a thermoplastic resin material which is heat-shrinkable; and
a step of heating and shrinking the film member to bring the film member into close contact with the configuration, covering the package main body portion and the cover member with the film member so as to surround the package main body portion and the cover member from a side, and performing at least one of fixing the cover member to the frame portion or fixing a member forming the frame portion to a member forming the substrate portion.
